# EUROPÄISCHE PATENTSCHRIFT

(11) **EP 3 354 121 B1**
(45) Veröffentlichungstag und Bekanntmachung des Hinweises auf die Patenterteilung: **09.09.2020**
(21) Anmeldenummer: 16801123.7
(22) Anmeldetag: 21.09.2016
(51) Int. Cl.: H05K 13/00, B65G 47/252, G01R 31/28

(54) **VERFAHREN ZUR WERKSTÜCKERFASSUNG SOWIE ERFASSUNGSVORRICHTUNG**
METHOD FOR SENSING WORKPIECES, AND SENSING DEVICE
PROCÉDÉ DE DÉTECTION DE PIÈCE ET DISPOSITIF DE DÉTECTION

(30) Priorität: 21.09.2015 DE 102015115934
(43) Veröffentlichungstag der Anmeldung: 01.08.2018
(73) Patentinhaber: Viscom Ag, 30455 Hannover (DE)
(72) Erfinder: HEUSER, Martin, 30455 Hannover (DE)
(74) Vertreter: Habenicht, Wieland
(86) Internationale Anmeldenummer: PCT/DE2016/000348
(87) Internationale Veröffentlichungsnummer: WO 2018/054402

(56) Entgegenhaltungen:
- EP-A1- 2 868 601
- EP-A2- 0 296 096
- WO-A1-96/35321
- JP-A- 2006 007 293
- US-A1- 2003 188 997

## Beschreibung

Die Erfindung betrifft ein Verfahren zur Werkstückerfassung sowie eine Erfassungsvorrichtung, durch die ein, insbesondere kontaktsensibles, Werkstück, vorzugsweise eine Leiterplatte, abschnittsweise in einem Erfassungsbereich einer Erfassungseinrichtung der Erfassungsvorrichtung erfasst wird.

Zur Erfassung von Werkstücken sind verschiedene Verfahren wie auch Erfassungsvorrichtungen aus dem Stand der Technik bekannt, durch die ein Werkstück ein- wie auch mehrseitig erfasst werden kann.

Dazu wird einer Erfassungsvorrichtung das Werkstück zugeführt, die dieses im Rahmen der Erfassungsmöglichkeiten im gewünschten Umfang erfasst.

Zur vorgenannten Erfassung eines Werkstückes können u.a. ein wie auch mehrere Erfassungsköpfe vorgesehen sein, um das Werkstück möglichst in einem gewünschten Umfang erfassen zu können, die nachfolgend verkürzt auch unter dem Begriff Erfassungskopf gefasst werden.

Zur Erfassung eines Werkstückes ist dieses zunächst in eine Erfassungsposition zu bringen, um vorgegebene Erfassungsbedingungen einzuhalten und den Erfassungsbereich der Erfassungsvorrichtung möglichst vollständig nutzen zu können.

Insbesondere eine Mehrseitenerfassung eines Werkstückes ist gegenwärtig noch problembehaftet und kostenaufwendig und in einigen Fällen aufgrund der notwendigen Anordnung des betreffenden Werkstücks auf einem Werkstückträger nur zeit-/kostenintensiv realisierbar.

Die eine schnelle umfassende Erfassung eines Werkstücks verhindernden Gründe liegen u.a. darin, dass während der Erfassung Abschnitte des Werkstückes abgeschattet bzw. verdeckt sein können.

Vor diesem Hintergrund sind aus dem Stand der Technik Verfahren zur Werkstückerfassung bzw. Erfassungsvorrichtungen der betreffenden Art bekannt, bei denen u.a. mehrere Erfassungseinrichtungen bzw. Erfassungsköpfe vorgesehen sind, um eine gewünschte Erfassung eines Werkstückes vornehmen zu können.

Aus dem Stand der Technik sind Verfahren zur Werkstückerfassung bekannt, bei denen ein, insbesondere kontaktsensibles, Werkstück, vorzugsweise eine Leiterplatte, abschnittsweise in einem Erfassungsbereich einer Erfassungsvorrichtung erfasst wird, wobei mittels Fördermitteln einer Fördereinrichtung ein erstes Werkstück mit dessen, beispielsweise und insbesondere bodenabgewandt orientierten, Oberseite einer Erfassungsvorrichtung zum Erreichen einer Erfassungsposition zugeführt wird.

Damit sind Verfahren zur Werkstückerfassung bekannt, bei denen mittels Fördermittel ein erstes Werkstück einer Erfassungseinrichtung zugeführt wird, durch die eine Oberseite des Werkstückes wenigstens abschnittsweise erfasst wird.

Des Weiteren sind Erfassungsvorrichtungen zur Ausführung eines Verfahrens zur Werkstückerfassung zur wenigstens abschnittsweisen Erfassung des Werkstückes aus dem Stand der Technik bekannt, die ausgestattet sind mit einer Fördereinrichtung, die ein erstes Werkstück, dessen Oberseite beispielsweise und insbesondere bodenabgewandt orientiert ist, einer Erfassungsposition zuführt, in der eine Erfassungseinrichtung einen Werkstückabschnitt des ersten Werkstücks wenigstens abschnittsweise erfasst.

WO96/35321 A1 offenbart ein Verfahren zur Werkstückerfassung, bei dem mittels Fördermittel ein erstes Werkstück einer Erfassungseinrichtung zugeführt wird, bei der eine Oberseite des Werkstückes wenigstens abschnittsweise erfasst wird, wobei in einem ersten Verfahrensabschnitt zur weiteren Erfassung des ersten Werkstückes das erste Werkstück nach wenigstens abschnittweiser Erfassung seiner Oberseite mittels der Fördermittel einem ersten Wendeorgan zugeführt wird, durch das daraufhin das ihr zum Wenden zugeführte erste Werkstück derart gewendet wird, dass das erste Werkstück im gewendeten Zustand mittels der Fördermittel zur abschnittsweisen Erfassung seiner Unterseite wieder zugeführt wird, sodass es nach wenigstens abschnittsweiser Erfassung seiner Unterseite mittels der Fördermittel in einer der Erfassungseinrichtung abgewandten Förderrichtung gefördet wird, wobei während des ersten Verfahrensabschnittes in einem zweiten Verfahrensabschnitt zur Erfassung des zweiten Werkstückes ein dem ersten Werkstück nachfolgendes zweites Werkstück der Erfassungseinrichtung zugeführt wird und nach wenigstens abschnittsweiser Erfassung seiner Oberseite mittels der Fördermittel einem zweiten Wendeorgan zugeführt wird, durch das daraufhin das durch ihr zum Wenden zugeführte zweite Werkstück derart gewendet wird, dass das zweite Werkstück im gewendeten Zustand mittels der Fördermittel zur abschnittsweisen Erfassung seiner Unterseite wieder zugeführt wird.

Daher sind Erfassungsvorrichtungen der betreffenden Art bekannt, bei denen mittels Fördermittel ein erstes Werkstück einer Erfassungseinrichtung zugeführt wird, durch die eine Oberseite des Werkstückes wenigstens abschnittsweise erfasst wird.

Die Nachteile, die den bekannten Verfahren zur Werkstückerfassung wie auch den bekannten Erfassungsvorrichtungen anhaften, liegen u.a. auch darin, dass diese in ihrer Anwendung kosten- bzw. raumintensiv sind.

Der Erfindung liegt die Aufgabe daher zugrunde, ein Verfahren zur Werkstückerfassung wie auch eine Erfassungsvorrichtung zur Durchführung des vorgenannten Verfahrens anzugeben, die den Aufwand zur Realisierung einer Werkstückerfassung senkt und die Investitionen und Instandhaltungskosten sowie den Raumbedarf für eine Erfassungsvorrichtung reduziert.

Die Lösung dieser Aufgabe wird durch die Gegenstände der unabhängigen Ansprüche 1 und 11 erreicht.

Die Erfindung entfernt sich zur Lösung der ihr gestellten Aufgabe zunächst von dem Ansatz, eine Erfassungsvorrichtung variabler zu gestalten, um die Position eines Erfassungskopfes zur Erfassung verschiedener Werkstückabschnitte verändern zu können.

Dies ist u.a. dem innerhalb der Erfindung festgestellten Umstand geschuldet, dass ein Wechsel des Erfassungskopfes zwischen verschiedenen Positionen toleranzbehaftet ist. Dadurch können bei einer, insbesondere mikroskopischen, Erfassung feiner Strukturen des betreffenden Werkstückes Erfassungsfehler die Folge sein, die wiederum zu einer aufwendigen Korrektur führen bzw. für die vorgesehenen Zwecke die Erfassungsdaten/-ergebnisse unbrauchbar machen.

Die Erfindung löst die ihr gestellte Aufgabe vielmehr auf überraschend einfache Weise dadurch, dass im Hinblick auf ein erfindungsgemäßes Verfahren zur Werkstückerfassung das Werkstück nach dessen wenigstens abschnittsweisen Erfassung einem ersten Wendeorgan zugeführt wird, welches das ihr zugeführte Werkstück derart wendet, dass dessen Oberseite nach dem Wendevorgang beispielsweise und insbesondere bodenzugewandt orientiert ist und daraufhin einer Erfassungseinrichtung einer erfindungsgemäßen Erfassungsvorrichtung zur Erfassung eines zweiten Werkstückabschnittes zugeführt wird.

Demgemäß ist ein erfindungsgemäßes Verfahren zunächst dadurch gekennzeichnet, dass in einem ersten Verfahrensabschnitt zur weiteren Erfassung des ersten Werkstückes das erste Werkstück nach wenigstens abschnittsweiser Erfassung seiner Oberseite mittels der Fördermittel einem ersten Wendeorgan zugeführt wird, durch das daraufhin das ihr zum Wenden zugeführte erste Werkstück derart gewendet wird, dass dieses im gewendeten Zustand mittels der Fördermittel zur wenigstens abschnittsweisen Erfassung seiner Unterseite der Erfassungseinrichtung wieder zugeführt wird, so dass es nach wenigstens abschnittsweiser Erfassung seiner Unterseite mittels der Fördermittel in einer der Erfassungseinrichtung abgewandten Förderrichtung gefördert wird.

Des Weiteren ist ein erfindungsgemäßes Verfahren dadurch gekennzeichnet, dass während des ersten Verfahrensabschnittes in einem zweiten Verfahrensabschnitt zur Erfassung des zweiten Werkstückes ein dem ersten Werkstück nachfolgendes zweites Werkstück der Erfassungseinrichtung zugeführt wird und nach wenigstens abschnittsweiser Erfassung seiner Oberseite mittels der Fördermittel einem zweiten Wendeorgan zugeführt wird, durch das daraufhin das ihr zum Wenden zugeführte zweite Werkstück derart gewendet wird, dass dieses im gewendeten Zustand der Erfassungseinrichtung zur wenigstens abschnittsweisen Erfassung seiner Unterseite mittels der Fördermittel wieder zugeführt wird.

Die Erfindung fußt u.a. auf dem Gedanken, die logistischen Prozesse für die zuvor beschriebene beidseitige Erfassung von Werkstücken dadurch zu verbessern, dass Stillstandszeiten einer Erfassungsvorrichtung minimal gehalten werden können.

Die Oberseite eines Werkstückes ist dabei vor deren wenigstens abschnittsweisen Erfassung beispielsweise und insbesondere bodenabgewandt orientiert, während demgemäß dessen Unterseite vor deren wenigstens abschnittsweisen Erfassung bodenzugewandt orientiert ist.

Im Rahmen der Erfindung ist ein Boden insbesondere dadurch bestimmt, dass dieser die Aufstellfläche für eine entsprechende Erfassungsvorrichtung bildet. Insofern ist unter bodenzugewandt zu verstehen, dass die betreffende Unterseite dem vorgenannten Boden zugewandt ausgerichtet ist. Dementsprechend ist unter dem Begriff bodenabgewandt zu verstehen, dass die betreffende Seite dem Boden abgewandt ist.

Ferner ist im Rahmen der Erfindung durch eine Förderrichtung die Richtung zu verstehen, in der die Fördermittel ein Werkstück bzw. die Werkstücke fördern.

Die Erfindung führt neben den Vorteilen geringer Kosten und eines geringen Raumbedarfs ebenfalls dazu, dass eine Kalibrierung der Erfassungsvorrichtung bzw. der weiteren Bestandteile zur Werkstückerfassung einfacher ist, da im einfachsten Fall lediglich ein Erfassungskopf zur Werkstückerfassung vorgesehen ist.

Ein Erfassungskopf, mittels dem die wenigstens abschnittsweise Erfassung einer Ober-/Unterseite eines Werkstückes erfolgt, ist beispielsweise und insbesondere für einen Erfassungsvorgang der wenigstens abschnittsweise zu erfassenden Oberseite (respektive der wenigstens abschnittsweise zu erfassenden Unterseite) zugewandt und zu dieser beispielsweise und insbesondere orthogonal ausgerichtet, um den gewünschten Erfassungsbereich erfassen zu können. Die Ausbildung und Einrichtung eines Erfassungskopfes richtet sich dabei jedoch nach dem gewünschten Erfassungsbereich und der Art der Erfassung.

Die Erfindung führt neben den vorgenannten Vorteilen zu dem Vorteil, dass eine wenigstens abschnittsweise Erfassung eines Werkstückes in einem kleineren Zeitfenster erfolgt, so dass ein erfindungsgemäßes Verfahren wie auch eine erfindungsgemäße Erfassungsvorrichtung gegenüber den bekannten Verfahren/Erfassungsvorrichtungen eine höhere Effizienz aufweisen und daher im gleichen Zeitfenster eine höhere Anzahl von Werkstücken durch lediglich eine Erfassungseinrichtung gegenüber den bekannten Verfahren bzw. Erfassungsvorrichtungen erfassbar sind.

Ferner führt die Erfindung zu dem Vorteil, dass eine weitreichende Anwendung zur Werkstückerfassung erschlossen ist.

Die Erfindung entfaltet weitere Vorteile dadurch, dass einerseits die Kosten für die Bereitstellung einer Erfassungsvorrichtung zur Erfassung von Werkstücken reduziert werden kann. Ferner wird durch die Erfindung wird u.a. erreicht, dass die Stillstandzeit der Erfassungsvorrichtung minimal gehalten werden kann, so dass die Erfassungsvorrichtung für die abschnittsweisen Erfassung eines Werkstücks genutzt werden kann, während ein weiteres Werkstück mittels eines dafür vorgesehenen Wendeorgans gewendet wird.

Zudem ergibt sich durch die Erfindung weiterhin der Vorteil, dass bei Einsatz lediglich einer Erfassungseinrichtung Werkstücke betreffend ihre jeweiligen Oberseite wie auch ihre jeweiligen Unterseite erfasst werden können.

Erfindungsgemäß ist die Erfassung eines Werkstückes nicht auf dessen Ober- bzw. Unterseite beschränkt, sondern kann sich auch auf eine bzw. mehrere Seiten des Werkstückes beziehen oder diese entsprechend umfassen, welche in der entsprechende Orientierung des Werkstückes durch die Erfassungseinrichtung wenigstens abschnittsweise erfassbar sind, während sie in einer anderen Orientierung des Werkstückes schwieriger bzw. unzureichend oder nicht erfassbar sind.

Die Erfassung eines Werkstückes muss erfindungsgemäß daher nicht zwingend allseitig erfolgen, sondern kann auch auf einen oder mehrere Abschnitt(e) des Werkstückes, beispielsweise eine Seite, bezogen sein, wie dies die Oberseite bzw. die Unterseite eines Werkstückes sein kann.

In vielen Fällen reicht es aus, wenn eine Oberseite bzw. Unterseite eines Werkstückes durch eine Erfassungsvorrichtung wenigstens abschnittsweise erfasst wird, da die weiteren Seiten bzw. Flächen für die weitere Auswertung bedeutungslos sind. Vor diesem Hintergrund ist im Rahmen der Erfindung ebenfalls berücksichtigt, dass die Erfassung auf die Oberseite bzw. Unterseite eines Werkstückes konzentriert ist.

Für ein Wenden eines Werkstückes können je nach Ausbildung eines erfindungsgemäßen Verfahrens/einer erfindungsgemäßen Erfassungsvorrichtung unterschiedliche Möglichkeiten des Wendens eines Werkstückes vorgesehen sein.

Die Erfindung sieht vor, dass ein zum Wenden einem Wendeorgan zugeführtes Werkstück durch dieses um eine, insbesondere horizontale, Achse, vorzugswiese um 180 Winkelgrad, gewendet wird.

Nachdem das erste Werkstück bzw. das zweite Werkstück durch das betreffende Wendeorgan gewendet worden ist, ist dessen beispielsweise und insbesondere vor dem Wenden bodenabgewandt orientierte Ober-/Unterseite vorzugsweise um 180 Grad um die vorgenannte Achse gedreht worden, wodurch diese entsprechend bodenzugewandt orientiert ist. Dabei kann die dazu vorgesehene Wendeachse vorzugsweise horizontal und in Transportrichtung wie auch quer dazu ausgerichtet sein.

Des Weiteren ist es möglich, dass das betreffende Wendeorgan (erstes oder zweites Wendeorgan) keine Halbkreisdrehung um eine horizontale Achse vornimmt, sondern lediglich eine Teilkreisdrehung, um den Wendevorgang abzuschließen, wobei die Fördereinrichtung bzw. dessen Fördermittel entsprechend angepasst eingerichtet und ausgebildet sind.

Dazu ist in einer Weiterbildung der Erfindung der zuvor erwähnte Wendevorgang um 180 Grad dadurch berücksichtigt, dass das erste Wendeorgan und/oder das zweite Wendeorgan ein ihr zum Wenden zugeführtes Werkstück um 180 Winkelgrad wendet(n).

Vor diesem Hintergrund ermöglicht es die Erfindung, ein Wenden innerhalb eines kurzen Zeitraumes vorzunehmen. Des Weiteren bietet die Erfindung den Vorteil, dass der Aufwand zum Wenden eines Werkstückes gering gehalten werden kann, wodurch sich wiederum Kostenvorteile ergeben. Analoges ergibt sich daher gemäß einer entsprechenden vorteilhaften Weiterbildung einer erfindungsgemäßen Erfassungsvorrichtung.

Wie zuvor bereits ausgeführt ermöglicht es die Erfindung, die benötigte Zeit für die gewünschte Erfassung eines Werkstückes auf ein Minimum zu reduzieren. Dazu ist es erfindungsgemäß vorgesehen, dass das erste Werkstück dem ersten Wendeorgan zugeführt wird, während ein zweites Werkstück, das dem ersten Werkstück nachgeordnet/nachfolgend ist, der Erfassungseinrichtung zugeführt wird, um dessen Ober- bzw. Unterseite - wie zuvor beschrieben - zu erfassen.

Dazu ist in einer vorteilhaften Weiterbildung der Erfindung vorgesehen, dass der zweite Verfahrensabschnitt mit dem zweiten Verfahrensabschnitt zeitlich abgestimmt, insbesondere synchronisiert, ist.

Insofern erfolgt erfindungsgemäß die Erfassung einer Ober- bzw. Unterseite des betreffenden Werkstückes im Wechsel zwischen den Werkstücken. Verkürzt ausgedrückt wird ein Werkstück gewendet, während die Erfassungseinrichtung ein weiteres Werkstück hinsichtlich seiner Oberseite bzw. seiner Unterseite erfasst wird. Insofern sind die einzelnen Verfahrensschritte eines Verfahrensabschnittes zeitlich aufeinander abgestimmt bzw. zueinander synchronisiert.

Die Abfolge der einzelnen Verfahrensschritte innerhalb eines Verfahrensabschnitts erfolgt daher vorzugsweise in der Reihenfolge des Förderns, des Erfassens, des Wendens eines Werkstückes, wie sie zuvor angegeben wurden. Die einzelnen Phasen zur wenigstens abschnittsweisen Erfassung einer Ober-/ Unterseite sind zwischen erstem und zweiten Werkstück entsprechend zeitlich versetzt, insbesondere um einen Vorgang als Verfahrensschritt versetzt. Diesem Erfindungsgedanken folgt daher ebenfalls eine vorteilhafte Weiterbildung einer erfindungsgemäßen Erfassungsvorrichtung, wie diese nachfolgend erläutert wird.

Demgemäß wird vorteilhafter Weise erreicht, dass Vorgänge, durch die ein Werkstück einer Erfassungsvorrichtung zugeführt werden, derart mit einem Erfassungsvorgang abgestimmt sind, dass geringe Stillstandszeiten zwischen den Wechselvorgängen entstehen.

Aufgrund der Abstimmung der Vorgänge zueinander ist es ebenfalls möglich, dass der Aufwand für eine Steuerung bzw. Regelung der entsprechenden Vorgänge gering gehalten werden kann.

Im Rahmen der Erfindung wird vorteilhafter Weise erreicht, dass eine Erfassung eines Werkstückes durch lediglich eine Erfassungsvorrichtung in einem geringen Zeitfenster erfolgen kann, das hinsichtlich der einzelnen Vorgänge des Wendens bzw. des Erfassens optimiert werden kann. Dazu ist erfindungsgemäß ebenfalls und insbesondere vorgesehen, dass ein Wendevorgang, durch den das betreffende Werkstück, wie zuvor beschrieben, gewendet wird, synchronisiert ist mit einem Erfassungsvorgang, bei dem die vorgenannte Erfassung eines Werkstückabschnittes erfolgt. Insofern können aufgrund der notwendigen Zeiten für das Wenden eines Werkstückes zum mehrseitigen Erfassen eines Werkstückabschnittes aufeinander abgestimmt werden.

Dazu berücksichtigt eine erfindungsgemäße Weiterbildung der Erfindung hinsichtlich des Verfahrens, dass das erste Werkstück durch das erste Wendeorgan gewendet wird, während die Oberseite des zweiten Werkstücks wenigstens abschnittsweise durch die Erfassungseinrichtung erfasst wird, und insbesondere das zweite Werkstück durch das zweite Wendeorgan gewendet wird, während die Unterseite des ersten Werkstücks wenigstens abschnittsweise durch die Erfassungseinrichtung erfasst wird. Analoges gilt für eine erfindungsgemäße Ausgestaltung einer Erfassungsvorrichtung, die dazu entsprechend eingerichtet und ausgebildet ist.

Die vorgenannte Weiterbildung der Erfindung führt u.a. zu dem Vorteil, dass lediglich zwei Erfassungsvorgänge notwendig sind, um ein Werkstück in dem gewünschten Rahmen erfassen zu können.

Eine zeitliche Abstimmung der einzelnen Verfahrensschritte kann vorzugsweise dadurch erfolgen, dass das erste Wendeorgan und das zweite Wendeorgan hinsichtlich einer Förderstrecke gleich beabstandet zur Erfassungseinrichtung angeordnet sind, wie dies in einer vorteilhaften Weiterbildung der Erfindung betreffend eine erfindungsgemäße Erfassungsvorrichtung vorgesehen ist.

Dadurch ist auf überraschend einfache Art und Weise mittels der Erfindung erreicht, dass u.a. gleich ausgeführte Wendeorgane zur Bildung von erstem und zweitem Wendeorgan verwendbar sind und eine Abstimmung auf die wenigstens abschnittsweise Erfassung einer Ober-/Unterseite eines Werkstückes durch die Beabstandung der Wendeorgane zur Erfassungseinrichtung erfolgen kann.

Bei unterschiedlich gebildeten Wendeorganen, die ein Wenden von Werkstücken mit zueinander unterschiedlichem Zeitbedarf vornehmen, kann eine Kompensation des Zeitbedarfs durch die Wahl der Abstände des jeweiligen Wendeorgans zur Erfassungseinrichtung vorgenommen werden. Dadurch ermöglicht es die Erfindung die Einrichtung einer erfindungsgemäßen Erfassungsvorrichtung auf einfache und kostengünstige Art und Weise zu erreichen.

Die Erfassung eines Werkstückes kann auf unterschiedliche Art und Weise erfolgen. Eine schnelle Erfassung eines Werkstückes kann im Rahmen der Erfindung u.a. dadurch erfolgen, dass diese berührungsfrei erfolgt. Dabei wird durch eine berührungsfreie Erfassung erfindungsgemäß erreicht, dass das Werkstück zu dessen Erfassung unbeeinträchtigt bleibt.

Insofern ist es in der vorgenannten Weiterbildung der Erfindung berücksichtigt, dass die Erfassungsvorrichtung bzw. dessen Erfassungseinrichtung zur optischen Erfassung von Werkstückabschnitten eingerichtet und ausgebildet ist. Insofern ist in einer weiteren vorteilhaften Weiterbildung der Erfindung betreffend das Verfahren vorgesehen, dass die Erfassungsvorrichtung die Erfassung von Werkstücken bzw. von Werkstückabschnitten optisch vornimmt.

Vor diesem Hintergrund ist in einer Weiterbildung der Erfindung bezogen auf die Erfassungsvorrichtung und ein erfindungsgemäßes Verfahren berücksichtigt, dass die Erfassungsvorrichtung einen Werkstückabschnitt eines Werkstückes berührungsfrei, nämlich optisch, erfasst.

Nachdem im Rahmen der Erfindung die Erfassung eines Werkstückes abgeschlossen ist, befindet sich dieses nicht mehr hinsichtlich seiner Ober- und Unterseite in seiner ursprünglichen Orientierung, die diese vor einer erfindungsgemäßen Erfassung eingenommen haben.

Um beispielsweise und insbesondere weitere Bearbeitungsvorgänge zu vereinfachen und nicht gemäß der geänderten Orientierung des Werkstückes anpassen zu müssen, ist in einer weiteren vorteilhaften Weiterbildung der Erfindung berücksichtigt, dass das betreffende Werkstück seine ursprüngliche Orientierung zurück erhält, indem dieses nach dessen vorbeschriebenen Erfassung mittels der Fördermittel dem ersten oder zweiten Wendeorgan zugeführt und daraufhin derart gewendet wird, dass sich dessen jeweilige Oberseite in seiner ursprünglichen Orientierung, die das betreffende Werkstück vor dessen Erfassung durch die Erfassungseinrichtung hatte, befindet.

Für eine möglichst aufwandreduzierte Ausbildung einer erfindungsgemäßen Erfassungsvorrichtung und eines erfindungsgemäßen Verfahrens berücksichtigt eine weitere Weiterbildung der Erfindung, dass das erste Werkstück durch das erste Wendeorgan gewendet wird, während die Unterseite des zweiten Werkstücks wenigstens abschnittsweise durch die Erfassungseinrichtung erfasst wird und insbesondere das zweite Werkstück durch das erste Wendeorgan gewendet wird, während die Oberseite eines weiteren ersten Werkstücks wenigstens abschnittsweise durch die Erfassungseinrichtung erfasst wird.

Damit erfolgt für eine erfindungsgemäße Erfassung eines Werkstückes eine eindeutige Zuordnung von Wendeorgan und erstem/zweiten Werkstück. Demgemäß wird das erste Werkstück für dessen Erfassung im Rahmen der Erfindung durch das erste Wendeorgan und entsprechend zeitversetzt dazu das zweite Werkstück durch das zweite Wendeorgan für dessen Erfassung gewendet. Dadurch ist eine einfache Ausbildung eines Verfahrens wie auch einer Steuerung betreffend einer erfindungsgemäßen Erfassungsvorrichtung begünstigt.

Dem Erfindungsgedanken einer einfachen zeitlichen Abstimmung der Verfahrensschritte folgend sieht eine vorteilhafte Weiterbildung der Erfindung vor, dass die Fördermittel das zweite Werkstück der Erfassungseinrichtung zum Erfassen oder dem zweiten Wendeorgan zum Wenden zuführen, während sie das erste Werkstück dem ersten Wendeorgan oder der Erfassungseinrichtung zum Erfassen zuführen.

Zur wegoptimierten Ausgestaltung eines erfindungsgemäßen Verfahrens wie auch einer erfindungsgemäßen Erfassungsvorrichtung sieht eine vorteilhafte Weiterbildung der Erfindung vor, dass die Fördermittel für die wenigstens abschnittsweisen Erfassung der Unterseite des ersten Werkstückes durch die Erfassungseinrichtung bzw. für das Wenden des zweiten Werkstückes durch das zweite Wendeorgan die Förderrichtung für das jeweilige Werkstück umkehren, so dass das jeweilige Werkstück zur Erfassungseinrichtung oder zum Wendeorgan rückgeführt wird.

Demgemäß ist auch eine erfindungsgemäße Erfassungsvorrichtung hinsichtlich seiner Fördermittel derart eingerichtet und ausgebildet, dass die Förderrichtung der Fördermittel umkehrbar ist und dazu entsprechend durch die Steuerungsmittel angesteuert werden.

Es ergibt sich der Vorteil, dass die Förderstrecke einfach ausgestaltet werden kann, indem die Rückführung eines ersten bzw. zweiten Werkstückes in vorgenannter Art entlang einer Förderstrecke und einer Förderspur erfolgen kann, und die Werkstücke durch die Fördermittel daher vorwärts wie auch rückwärts entlang der Förderstrecke bewegt werden.

Es bedarf daher keiner weiteren Förderspur für die Ausbildung der Förderstrecke, entlang der eine Rückführung der vorgenannten Art erfolgen muss. Die Förderstrecke kann daher insbesondere auf eine zusätzliche Förderspur verzichten und daher vorzugswiese geradlinig ausgebildet sein. Demgemäß können der Aufwand reduziert und weitere Kostenvorteile erzielt werden.

Des Weiteren führt eine derartige Anordnung, wie sie in der vorgenannten vorteilhaften Weiterbildung vorgeschlagen ist, dazu, dass eine einfache Realisierung und Umsetzung eines erfindungsgemäßen Verfahrens durch eine erfindungsgemäße Erfassungsvorrichtung ermöglicht ist. Des Weiteren sind die Steuerungsprozesse für die Ausführung des erfindungsgemäßen Verfahrens durch eine erfindungsgemäße Erfassungsvorrichtung vereinfacht.

Diesem Erfindungsgedanken folgend ist in einer weiteren vorteilhaften Weiterbildung der Erfindung betreffend das Verfahren vorgesehen, dass das erste Werkstück und das zweite Werkstück durch die Fördermittel mittels einer gemeinsamen, insbesondere geradlinigen, Förderspur gefördert werden.

Erfindungsgemäß ist unter einer Förderspur insbesondere eine Bahn zu verstehen, entlang der Werkstücke gefördert/bewegt werden.

Die vorteilhafte Weiterbildung einer erfindungsgemäßen Erfassungsvorrichtung schließt sich diesem Erfindungsgedanken an.

In diesem Zusammenhang sieht eine weitere vorteilhafte Weiterbildung einer erfindungsgemäßen Erfassungsvorrichtung vor, dass die Fördermittel erstes und zweites Wertstück entlang einer Förderstrecke fördern, bei der das erste Wendeorgan der Erfassungsvorrichtung insbesondere hinsichtlich des Verlaufs der Förderstrecke räumlich nachgeordnet und das zweite Wendeorgan der Erfassungsvorrichtung entsprechend räumlich vorgeordnet ist.

Dadurch wird erreicht, dass zwischen erstem und zweitem Wendeorgan die Erfassungseinrichtung angeordnet ist, so dass eine erfindungsgemäße Erfassungsvorrichtung platzsparend eingesetzt werden kann. Wie bereits zuvor ausgeführt, ist es möglich, dass die Fördermittel einer Fördereinrichtung auf unterschiedliche Art und Weise realisiert werden können. Im Rahmen der Erfindung hat es sich als vorteilhaft gezeigt, dass sogenannte Stetigförderer eingesetzt werden, dessen Realisierung beispielsweise durch eine Fließbandtechnik erfolgen kann.

Insofern kommen im Rahmen der Erfindung zur Bildung von Fördermitteln, die auch einen Bestandteil eines Wendeorgans sein können, vorgenannte Stetigförderer zum Einsatz.

Dabei ist entscheidend, dass das Wenden eines Werkstückes dahingehend erfolgt, dass die Vorgänge, die dazu notwendig sind, möglichst einfach gehalten werden. Des Weiteren ist vorzusehen, dass das Werkstück möglichst nicht neu ausgerichtet werden muss.

Zur einfachen und sicheren Realisierung eines Wendevorganges ist in einer vorteilhaften Weiterbildung eines erfindungsgemäßen Verfahrens berücksichtigt, dass ein Werkstück durch wenigstens eines der Wendeorgane dadurch gewendet wird, indem wenigstens ein erster Stetigförderer und ein zweiter Stetigförderer um eine gemeinsame, insbesondere horizontale, Achse gedreht werden, sobald sich das Werkstück auf dem ersten Stetigförderer aufliegend zwischen erstem und zweitem Stetigförderer in einer Wendeposition befindet, und nach dem Wendevorgang durch den zweiten Stetigförderer in einer der Erfassungseinrichtung zugewandten oder abgewandten Richtung gefördert wird.

Dadurch ist vorteilhafter Weise erreicht, dass das Werkstück während eines Wendevorganges sicher gehalten ist und seine Ausrichtung zum Wendeorgan nicht verliert. Des Weiteren ergibt sich vorteilhafter Weise durch die vorgenannte Weiterbildung der Erfindung, dass ein Wenden innerhalb eines kurzen Zeitfensters ermöglicht ist. Zudem erlaubt diese vorteilhafte Weiterbildung der Erfindung, dass das Zuführen eines Werkstückes zu dem betreffenden Wendeorgan vereinfacht ist, in dem der Abstand zwischen erstem und zweitem Stetigförderer entsprechend ver-/ einstellbar ist.

Die vorteilhafte Ausbildung einer erfindungsgemäßen Erfassungsvorrichtung folgt diesem Erfindungsgedanken.

Im Rahmen der Erfindung wird als bevorzugte Variante vorgeschlagen, das die Fördermittel sogenannte Stetigförderer vorsehen, durch die eine kontinuierliche Förderung, einfache Realisierbarkeit wie auch kostengünstige Instandhaltbarkeit ermöglicht sind, wie dies im weiteren in einer vorteilhaften Weiterbildung der Erfindung hinsichtlich des Verfahrens bzw. der Erfassungsvorrichtung vorgesehen ist.

Für den Wendevorgang eines Werkstückes sieht die Erfindung in einer weiteren vorteilhaften Weiterbildung seines Verfahrens vor, dass ein Werkstück durch wenigstens eines der Wendeorgane dadurch gewendet wird, indem wenigstens ein erster Stetigförderer und ein zweiter Stetigförderer um eine gemeinsame, insbesondere horizontale, Achse gedreht werden, sobald sich das Werkstück auf dem ersten Stetigförderer aufliegend zwischen erstem und dem zweiten Stetigförderer in einer Wendeposition befindet, und danach durch den zweiten Stetigförderer in einer der Erfassungseinrichtung zugewandten oder abgewandten Richtung gefördert wird.

Demgemäß kann der Wendevorgang unter Nutzung einer gemeinsamen Achse von Werkstück und Wendeorgan eine einfache Realisierung einer entsprechenden Erfassungsvorrichtung erlauben, wodurch ebenfalls Korrekturen des Werkstückes hinsichtlich seiner Ausrichtung entbehrlich sind bzw. reduziert werden können. Daher ist auch eine Weiterbildung einer erfindungsgemäßen Erfassungsvorrichtung entsprechend realisierbar.

Des Weiteren ist vom Erfindungsgedanken auch umfasst, dass die Fördermittel wenigstens einen Stetigförderer zur wenigstens abschnittsweisen Förderung eines Werkstückes aufweisen, wie dies in einer weiteren vorteilhaften Weiterbildung der Erfindung berücksichtigt ist. Vor diesem Hintergrund können die Fördermittel unter Nutzung verschiedener Arten von Stetigförderern gebildet werden, beispielsweise unter Nutzung von Ketten- oder Gurtbandtrieben. Die Umsetzung dieses Erfindungsgedanken ist für den betreffenden Fachmann kein Hindernis und bedarf daher an dieser Stelle keiner weiteren Erläuterung.

Aufgrund der Erfassung der Werkstückabschnitte von insbesondere der Ober- und Unterseite kann ein Werkstück im Rahmen der Erfindung (nahezu) vollumfänglich erfasst werden, indem die erfassten Daten eines Werkstückes miteinander kombiniert werden, so dass diese Daten das betreffende Werkstück repräsentieren.

Die durch die Erfassungsvorrichtung gewonnenen Daten können für verschiedene Zwecke ausgewertet werden. Beispielsweise können auf der Grundlage der Erfassung eines Werkstückes durch die Erfassungsvorrichtung verschiedene Rückschlüsse gezogen werden, so dass beispielsweise daraufhin eine Auswertung hinsichtlich des Erreichens von Qualitätsvorgang durch das betreffende Werkstück geprüft werden kann. Demgemäß können Fehler identifiziert werden, die ein Werkstück aufweist. Darüber hinaus ist es möglich, aufgrund dieser Daten ein Werkstück aus dem weiteren Bearbeitungsprozess auszusondern bzw. dieses einer gesonderten Bearbeitung zuzuführen.

Dazu ist in einer weiteren vorteilhaften Weiterbildung der Erfindung vorgesehen, dass die durch die Erfassungsvorrichtung erfassten Daten einer Auswertungseinrichtung zur weiteren Datenverarbeitung bereitgestellt werden.

Demgemäß sind im Rahmen der Erfindung die Erfassungsvorrichtung wie auch die Auswertungseinrichtung datenverarbeitungs- und signaltechnisch miteinander verbunden. Es entsteht - wie bereits zuvor ausgeführt - der Vorteil, die erfassten Daten für unterschiedliche Zwecke nutzen und beispielsweise auch dahingehend, Steuerungssignale für weitere Erfassungsvorrichtungen bzw. Einrichtungen zu erzeugen.

Die vorstehenden Ausführungen haben gezeigt, dass die Merkmale einer erfindungsgemäßen Erfassungsvorrichtung in Zusammenhang stehen mit einem erfindungsgemäßen Verfahren, so dass die betreffenden Merkmale wechselseitig für das betreffende Verfahren wie auch für die betreffenden Erfassungsvorrichtung gelten.

Die Erfindung wird nachfolgend anhand der beigefügten Zeichnung näher erläutert, in der stellvertretend für eine Vielzahl erfindungsgemäß ein Ausführungsbeispiel einer erfindungsgemäßen Erfassungsvorrichtung gezeigt ist. Anhand der Darstellung wird ebenfalls ein erfindungsgemäßes Verfahren erläutert.

Die Figuren der Zeichnung zeigen die Ausführungsbeispiele einer erfindungsgemäßen Erfassungsvorrichtung in jeweils einer schematischen Darstellung. Die Darstellungen sind daher insbesondere nicht maßstabsgetreu und zur besseren Übersicht auf die das Verständnis unterstützenden Elemente/Bauteile/Bestandteile reduziert.

In den Figuren sind gleiche oder sich entsprechende Bauteile/Bestandteile bzw. Elemente mit den gleichen Bezugszeichen versehen. Ferner wird bei gleichem oder ähnlichem Aufbau zur besseren Übersicht die Beschreibung auf die Unterschiede zwischen den Darstellungen bzw. Figuren konzentriert.

Es zeigt:
FIG. 1 ein Ausführungsbeispiel einer erfindungsgemäßen Erfassungsvorrichtung in einer schematischen Seitenansicht, in der ein erster Verfahrensschritt veranschaulicht ist;
FIG. 2 das Ausführungsbeispiel aus FIG. 1 in gleicher Darstellungsweise, in der ein zweiter Verfahrensschritt gezeigt ist;
FIG. 3 ein Ausführungsbeispiel aus FIG. 1 in gleicher Darstellungsweise, in der ein dritter Verfahrensschritt gezeigt ist;
FIG. 4 das Ausführungsbeispiel aus FIG. 1 in gleicher Darstellungsweise, in der ein vierter Verfahrensschritt gezeigt ist;
FIG. 5 ein Ausführungsbeispiel aus FIG. 1 in gleicher Darstellungsweise, in der ein fünfter Verfahrensschritt gezeigt ist;
FIG. 6 das Ausführungsbeispiel aus FIG. 1 in gleicher Darstellungsweise, in der ein sechster Verfahrensschritt gezeigt ist;
FIG. 7 ein Ausführungsbeispiel aus FIG. 1 in gleicher Darstellungsweise, in der ein siebter Verfahrensschritt gezeigt ist;
FIG. 8 das Ausführungsbeispiel aus FIG. 1 in gleicher Darstellungsweise, in der ein achter Verfahrensschritt gezeigt ist;
FIG. 9 ein Ausführungsbeispiel aus FIG. 1 in gleicher Darstellungsweise, in der ein neunter Verfahrensschritt gezeigt ist;
FIG. 10 das Ausführungsbeispiel aus FIG. 1 in gleicher Darstellungsweise, in der ein zehnter Verfahrensschritt gezeigt ist;
FIG. 11 ein Ausführungsbeispiel aus FIG. 1 in gleicher Darstellungsweise, in der ein elfter Verfahrensschritt gezeigt ist;
FIG. 12 das Ausführungsbeispiel aus FIG. 1 in gleicher Darstellungsweise, in der ein zwölfter Verfahrensschritt gezeigt ist;
FIG. 13 ein Ausführungsbeispiel aus FIG. 1 in gleicher Darstellungsweise, in der ein dreizehnter Verfahrensschritt gezeigt ist;
FIG. 14 das Ausführungsbeispiel einer erfindungsgemäßen Erfassungsvorrichtung in einer in FIG. 2 gekennzeichneten Ansicht A-A,
FIG. 15 einen zeitlichen Ablauf von Vorgängen eines erfindungsgemäßen Verfahrens in einer schematischen Übersicht.

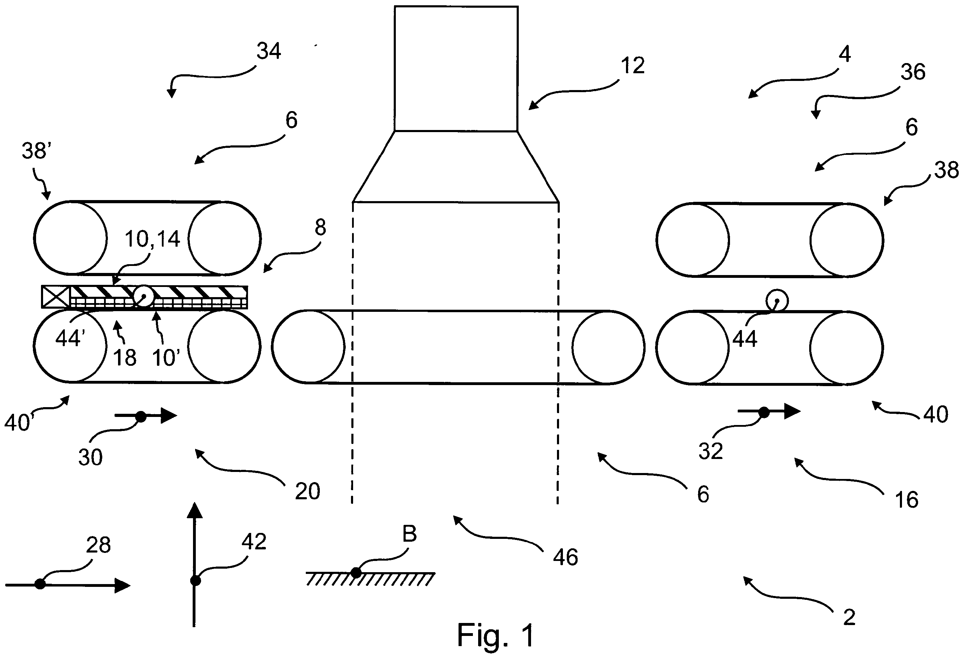

FIG. 1 zeigt ein Ausführungsbeispiel einer erfindungsgemäß gebildeten Erfassungsvorrichtung 2 zur Durchführung eines erfindungsgemäßen Verfahrens, wie dieses vorstehend beschrieben worden ist.

Die Erfassungsvorrichtung 2 ist ausgestattet mit einer Fördereinrichtung 4, die mittels Fördermitteln 6 ein erstes Werkstück 8, dessen Oberseite 10 bodenabgewandt orientiert ist, einer Erfassungsposition zuführt, in der eine Erfassungsvorrichtung 12 einen ersten Werkstückabschnitt 14 des ersten Werkstücks 8 erfasst.

Die Fördereinrichtung 4 führt mittels der Fördermittel 6 das von der Erfassungseinrichtung 12 hinsichtlich dessen erfasstes erste Werkstück 8 einem ersten Wendeorgan 16 zu, dass das diesem zum Wenden zugeführte erste Werkstück 8 derart wendet, dass dessen Boden B abgewandt orientierte Oberseite 10 nach dem Wendevorgang dem Boden B zugewandt orientiert ist, so dass daraufhin die Fördermittel 6 der Fördereinrichtung 4 das erste Werkstück 8 in dieser Orientierung der Erfassungsvorrichtung 12 zur Erfassung eines zweiten Werkstückabschnitts 18 wieder zuführen.

Des Weiteren weist die Erfassungsvorrichtung 2 ein zweites Wendeorgan 20 auf, das ein durch die Fördermittel 6 der Fördereinrichtung 4 zum Wenden zugeführtes, dem ersten Werkstück 8, insbesondere direkt, nachgeordnetes/nachfolgendes zweites Werkstück 22 (in FIG. 1 nicht gezeigt), derart wendet, dass dessen dem Boden B abgewandt orientierte Oberseite 24 (in FIG. 1 nicht gezeigt) nach dem Wendevorgang dem Boden B zugewandt orientiert ist, so dass daraufhin mittels der Fördermittel 6 der Fördereinrichtung 4 das zweite Werkstück 22 der Erfassungsvorrichtung 12 zur Erfassung dessen zweiten Werkstückabschnittes 26 seiner Unterseite 10' wieder zugeführt wird, wobei während des vorgenannten Wendevorgangs des zweiten Werkstücks Oberseite 24 bereits abschnittsweise durch die Erfassungseinrichtung 12 erfasst wurde. Diese Vorgänge werden anhand der weiteren Figuren deutlich.

In FIG. 1 ist ersichtlich, dass das erste Wendeorgan 16 zum zweiten Wendeorgan 20 derart beabstandet angeordnet ist, dass der Wendevorgang für ein erstes Werkstück 8 zeitlich korrespondierend/abgestimmt, in diesem Ausführungsbeispiel synchronisiert, erfolgt, zum Vorgang eines abschnittsweisen Erfassens eines weiteren Werkstückes 22. Analoges gilt für die Erfassung des zweiten Werkstückes 22 und das Wenden des ersten Werkstückes 8.

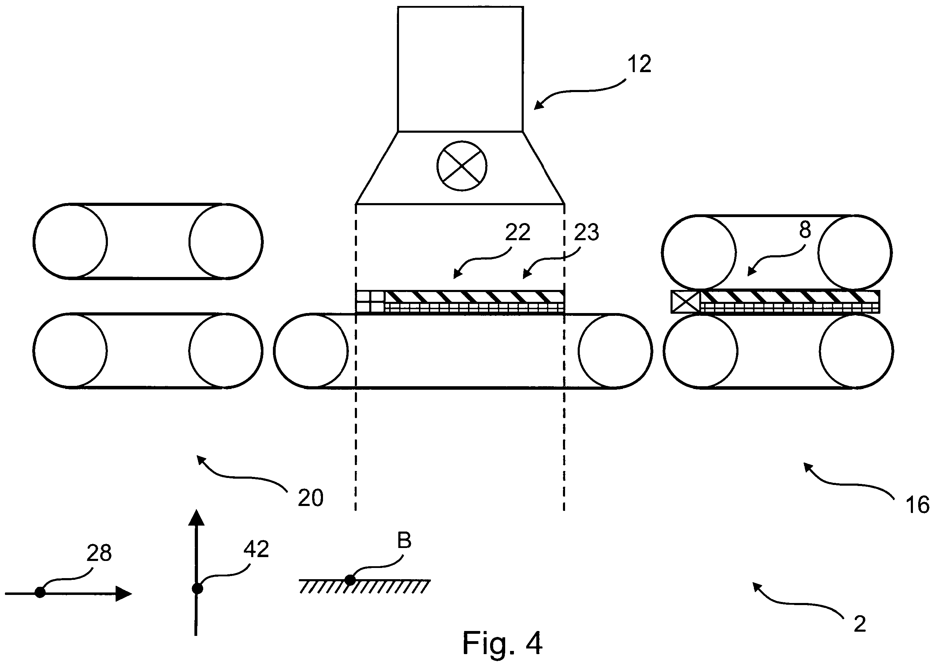

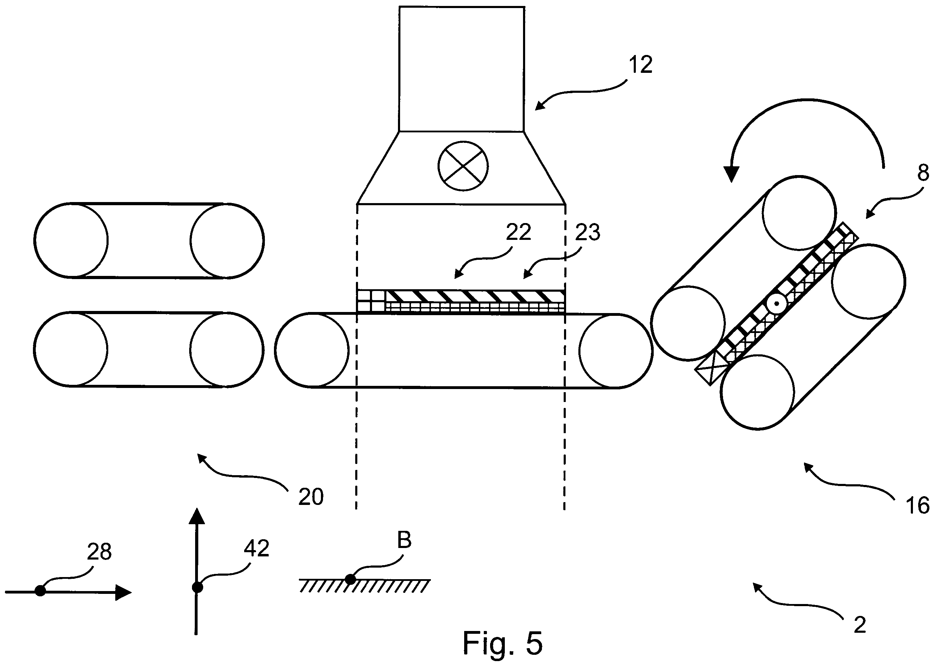

Dazu ist vorgesehen, dass das erste Werkstück 8 durch das erste Wendeorgan 16 gewendet wird, während die Oberseite 24 des zweiten Werkstücks 22 wenigstens abschnittsweise durch die Erfassungseinrichtung 12 erfasst wird. Dies ist in FIG. 4 bzw. FIG. 5 veranschaulicht.

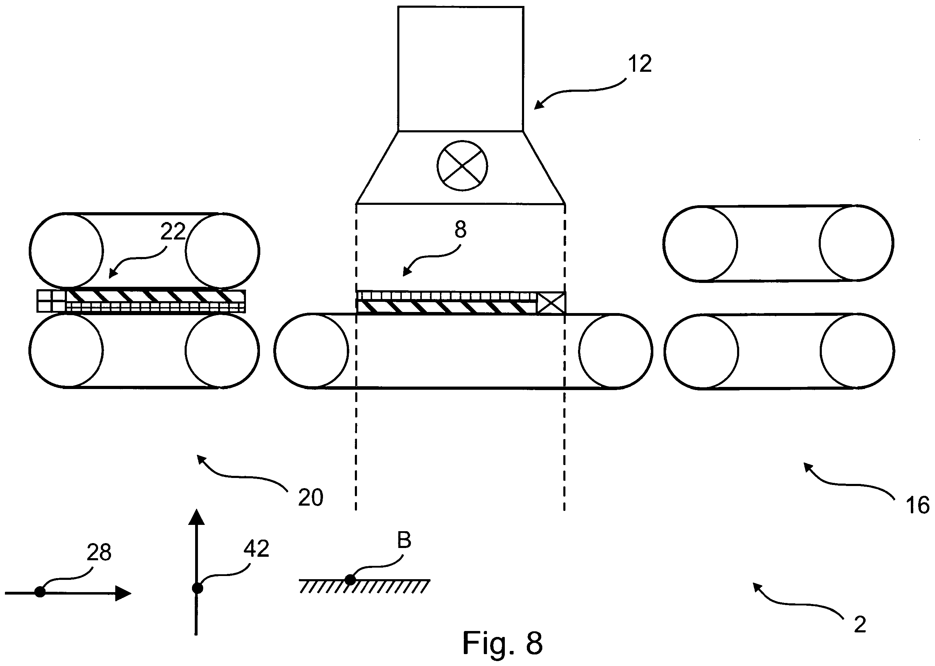

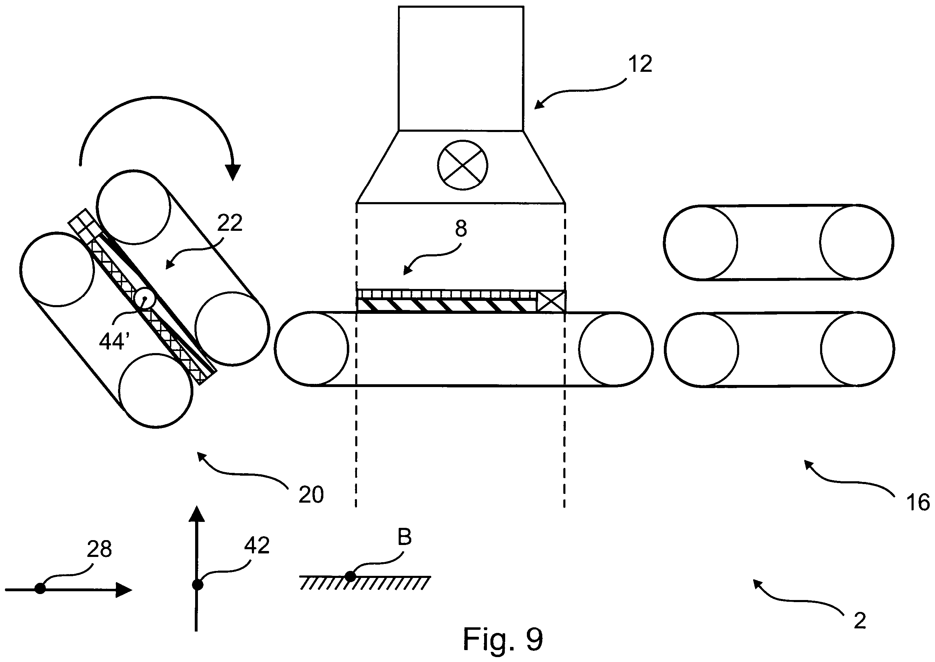

Des Weiteren ist vorgesehen, dass das zweite Werkstück 22 durch das zweite Wendeorgan 20 gewendet wird, während die Unterseite 10' des ersten Werkstücks 8 wenigstens abschnittsweise durch die Erfassungseinrichtung 12 erfasst wird. Dieser Vorgang ist in FIG. 8 bzw. FIG. 9 veranschaulicht.

Darüber hinaus ist in FIG. 1 gezeigt, dass das erste Wendeorgan 8 bezogen auf die Förderstrecke 28 der Erfassungsvorrichtung 2 räumlich nachgeordnet ist und insbesondere das zweite Wendeorgan 20 der Erfassungsvorrichtung 12 bezogen auf die Förderstrecke 28 räumlich vorgeordnet ist. Dadurch ergibt es sich, dass zwischen den Wendeorganen 16, 20 die Erfassungsvorrichtung 12 räumlich angeordnet ist.

Durch die Anordnung der Wendeorgane 16, 20 zur Erfassungseinrichtung 12 ergibt es sich, dass für ein Zuführen eines Werkstückes 8, 22 die betreffende Förderrichtung 30, 32 des jeweiligen Förderabschnittes 34, 36, die dem jeweiligen Wendeorgan 16, 20 zugeordnet sind, gegenüber der Förderstrecke 28 umgekehrt wird.

Die Förderrichtungen 30, 32 des ersten Werkstücks 8 und des zweiten Werkstücks 22 sind dabei aufgrund der zeitlichen Abstimmung der Vorgänge zueinander gleichgerichtet. Die Erfindung lässt jedoch auch eine davon abweichende Ausrichtung der betreffenden Förderrichtung 30, 32 des jeweiligen Werkstücks 8, 22 zu, insbesondere zum Ausgleich einer zeitlichen Abweichung der aufeinander abgestimmten Vorgänge.

Bei der in FIG. 1 gezeigten Erfassungsvorrichtung 2 weisen sowohl das erste Wendeorgan 16 wie auch das zweite Wendeorgan 20 jeweils wenigstens einen ersten Stetigförderer 38, 38' und einen zweiten Stetigförderer 40, 40' auf, die derart in vertikaler Richtung 42 übereinander und zueinander beabstandet angeordnet sind, dass sich zum Wenden das erste oder zweite Werkstück 8, 22 auf dem jeweiligen ersten Stetigförderer 38, 38' aufliegend zwischen dem jeweils ersten und zweiten Stetigförderer 38, 38', 40, 40' befindet, so dass ein gemeinsames Drehen der jeweiligen ersten und zweiten Stetigförderern 38, 38', 40, 40' um eine horizontale Achse 24 bewirkt, dass nach dem Drehen das betreffende Werkstück 8, 22 auf dem jeweiligen zweiten Stetigförderer 40, 40' aufliegt und durch diesen förderbar ist.

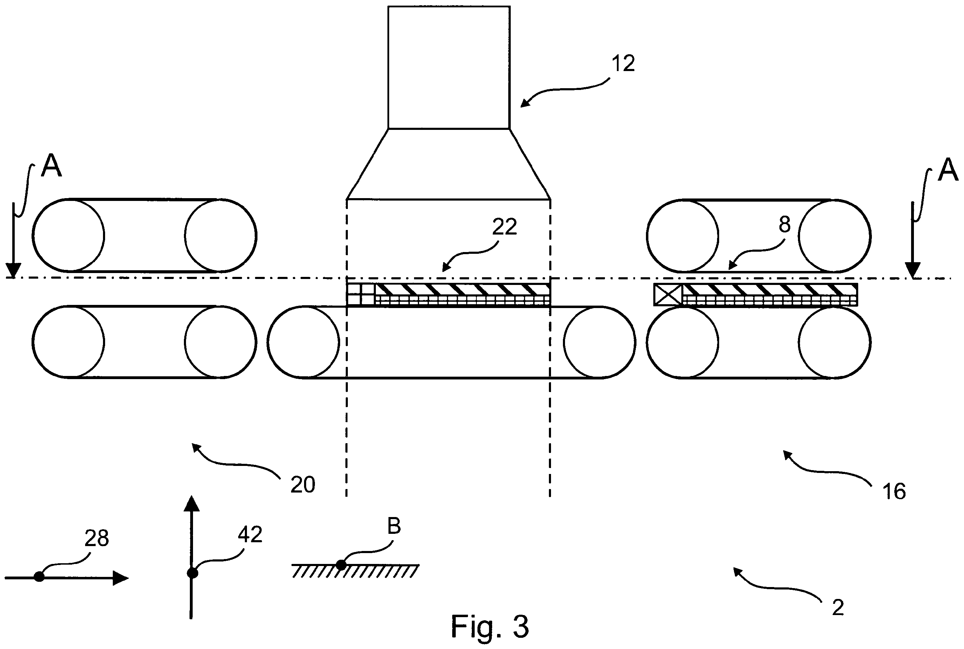

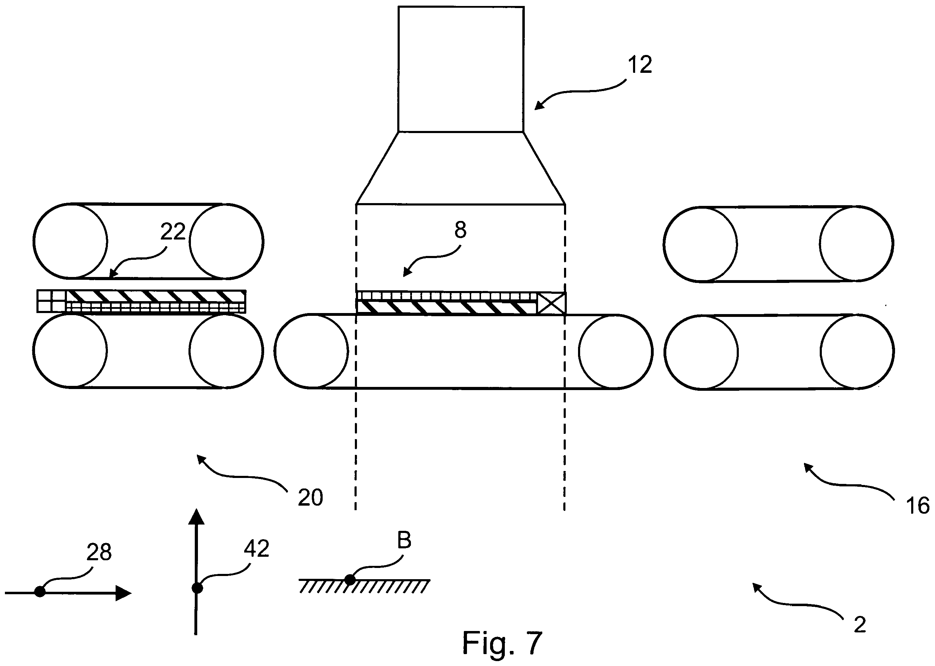

Um ein sicheres Wenden eines Werkstückes 8, 22 zu ermöglichen, ist der Abstand zwischen oberem Stetigförderer 40, 40' und unterem Stetigförderer 38, 38' verstellbar. Der Abstand ist bei diesem Ausführungsbeispiel einer erfindungsgemäßen Erfassungsvorrichtung 2 automatisiert verstellbar. Das Verstellen des vorgenannten Abstandes erfolgt derart, dass das betreffende Werkstück 8, 22 zwischen den jeweiligen Stetigförderern 38, 38', 40, 40' des dem betreffenden Werkstück 8, 22 zugeordneten Wendeorgans 16, 20 einführbar ist und für einen Wendevorgang für ein verschiebungsminimiertes Halten des betreffenden Werkstücks 8, 22 verringerbar ist. Dies ist anhand der FIG. 3 und FIG. 4 betreffend das erste Wendeorgan 16, wie auch anhand FIG. 7 und FIG. 8 erkennbar.

Die Wendeorgane 16, 20 sind in FIG. 1 in einer Öffnungsstellung gezeigt, während das erste Wendeorgan 16 in FIG. 4 bzw. das zweite Wendeorgan in FIG. 8 in einer Schließstellung gezeigt ist.

In FIG. 1 ist ein erster Schritt eines erfindungsgemäßen Verfahrens gezeigt, bei dem kontaktsensible Werkstücke 8, 22, welches in diesem Fall Leiterplatten sind, abschnittsweise in einem Erfassungsbereich 46 einer Erfassungsvorrichtung 12 erfasst wird, dem es zuvor durch die Fördermittel 6 zugeführt wurde.

Dabei wird mittels der Fördermittel 6 der Fördereinrichtung 4 ein erstes Werkstück 8 mit dessen bodenabgewandt orientierter Oberseite 10 der Erfassungsvorrichtung 12 zum Erreichen einer Erfassungsposition zugeführt (FIG. 1).

Nachdem das erste Werkstück 8 die vorgenannte Erfassungsposition im Erfassungsbereich 46 erreicht hat, wird ein erster Werkstückabschnitt 14, der sich auf der Oberseite 10 des ersten Werkstückes 8 befindet, durch die Erfassungsvorrichtung 12 erfasst.

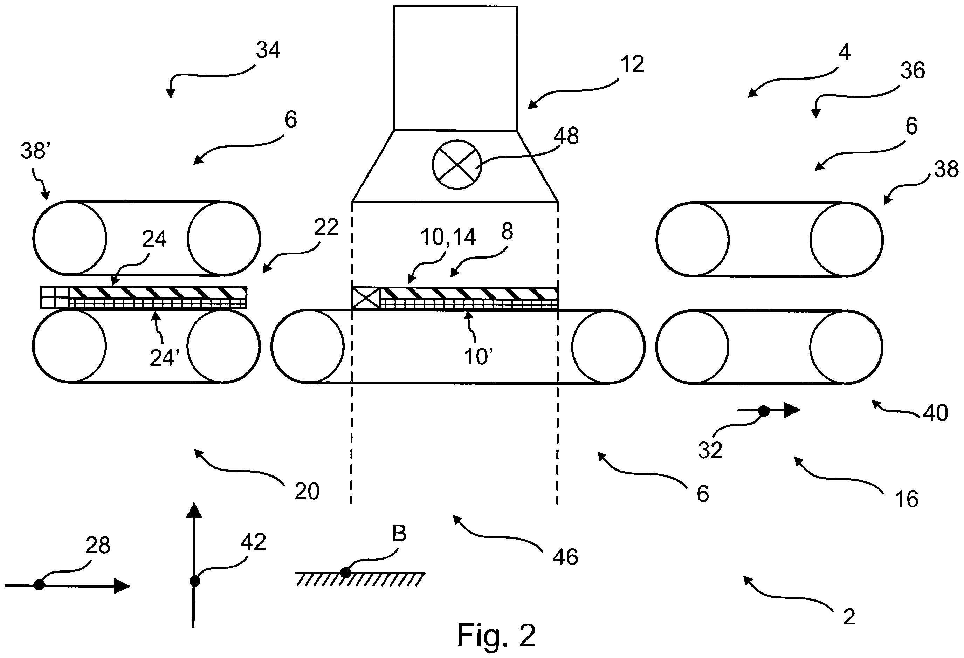

Das Erfassen des ersten Werkstückabschnittes 14 des ersten Werkstückes 8 ist in FIG. 2 durch das Symbol 48 symbolisiert ist. Dieses wird ebenfalls zur Kennzeichnung eines Erfassungsvorganges in den weiteren Figuren verwendet.

In FIG. 3 ist ein weiterer Schritt eines erfindungsgemäßen Verfahrens gezeigt, bei dem mittels der Fördermittel 6 das erste Werkstück 8 nach Erfassung dessen ersten Werkstückabschnittes 14 seiner Oberseite 10 dem ersten Wendeorgan 16 der Fördereinrichtung 4 zugeführt wird. Das erste Wendeorgan 16 wendet das ihr zum Wenden zugeführte erste Werkstück 8 derart, dass dieses nach dem Wendevorgang mit dessen bodenzugewandt orientierter Oberseite 10 der Erfassungsvorrichtung 12 zur Erfassung eines zweiten Werkstückabschnittes 18, der sich auf dessen Unterseite 10' befindet, wieder zugeführt wird.

Das Wenden des ersten Werkstückes 8 innerhalb des Wendevorgangs ist schematisiert in FIG. 5 gezeigt.

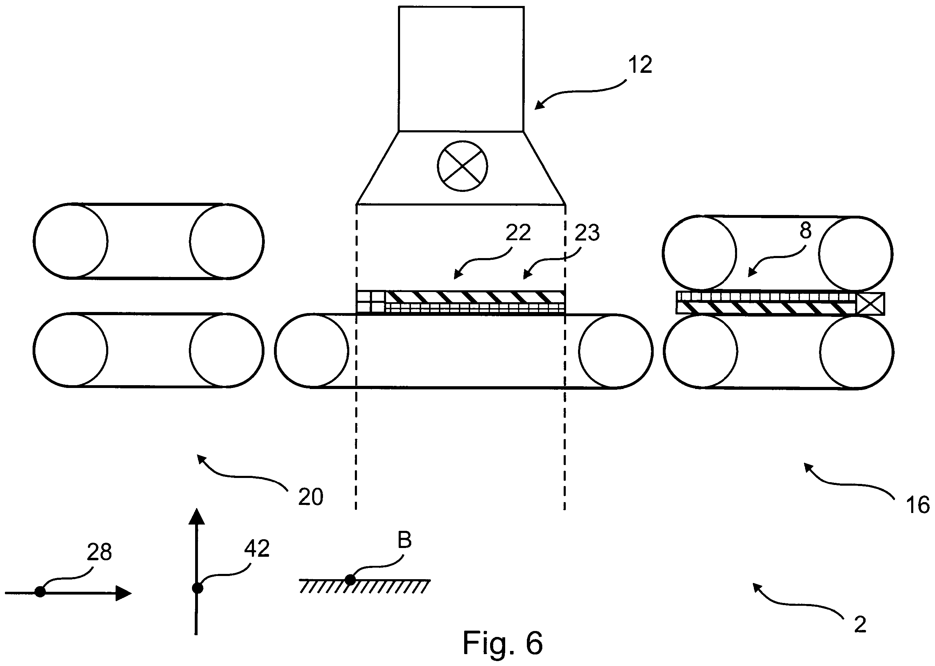

Das erneute Zuführen des ersten Werkstücks 8 zur Erfassungsvorrichtung 12 in der FIG. 6 veranschaulicht ist.

In FIG. 2 ist ebenfalls ein dem ersten Werkstück 8 direkt nachgeordnetes zweites Werkstück 22 gezeigt, das mittels der Fördermittel 6 mit dessen bodenabgewandt orientierter Oberseite 24 der Erfassungsvorrichtung 12 zum Erreichen einer Erfassungsposition zugeführt wird.

Das Erreichen der Erfassungsposition durch das zweite Werkstück 22 ist in FIG. 3 ersichtlich.

Fig. 6 zeigt, dass - nach Erreichen der Erfassungsposition durch das zweite Werkstück 22 - des zweiten Werkstücks 22 erster Werkstückabschnitt 23, der sich auf dessen Oberseite 24 befindet, durch die Erfassungsvorrichtung 12 erfasst wird.

Nach Erfassen des ersten Werkstückabschnittes 23 der Oberseite 24 des zweiten Werkstücks 22 wird dieses dem zweiten Wendeorgan 20 der Fördereinrichtung 4 zugeführt. Dies ist anhand von FIG. 6 und FIG. 7 veranschaulicht.

Das zweite Wendeorgan 20 wendet das diesem zum Wenden zugeführte zweite Werkstück 22 derart, dass das zweite Werkstück nach dem Wendevorgang mit dessen bodenzugewandt orientierter Oberseite 24 der Erfassungsvorrichtung 12 zur Erfassung eines zweiten Werkstückabschnittes 26 wieder zugeführt wird.

Das Wenden des zweiten Werkstückes 22 durch das zweite Wendeorgan 20 um eine horizontale Achse 44' ist in FIG. 9 gezeigt.

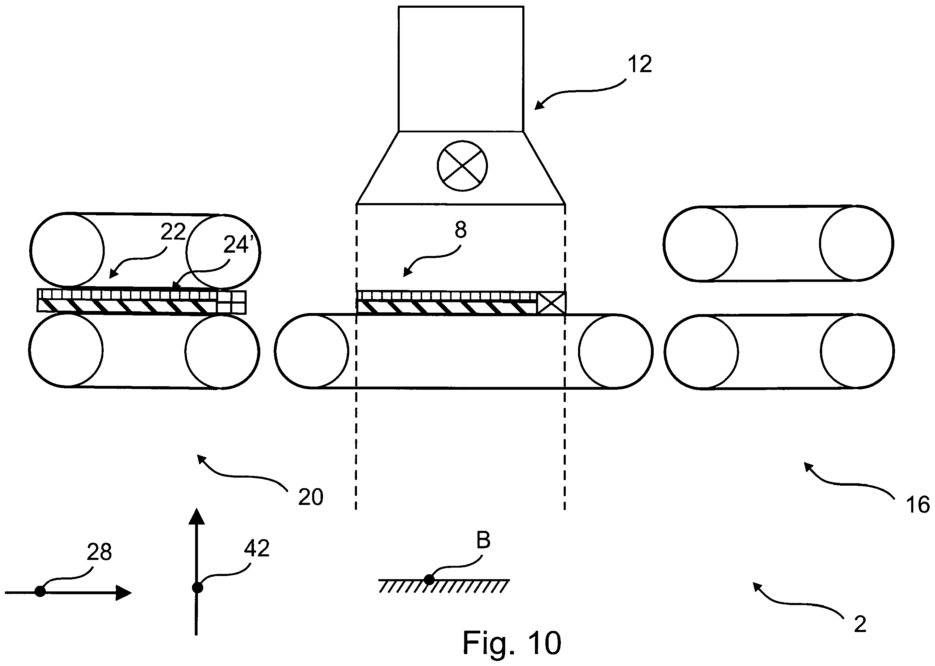

Der Abschluss des Wendevorgangs für das zweite Werkstück 22 ist in FIG. 10 gezeigt. Der Wendevorgang ist dabei analog gestaltet zum Wendevorgang eines ersten Werkstücks 8.

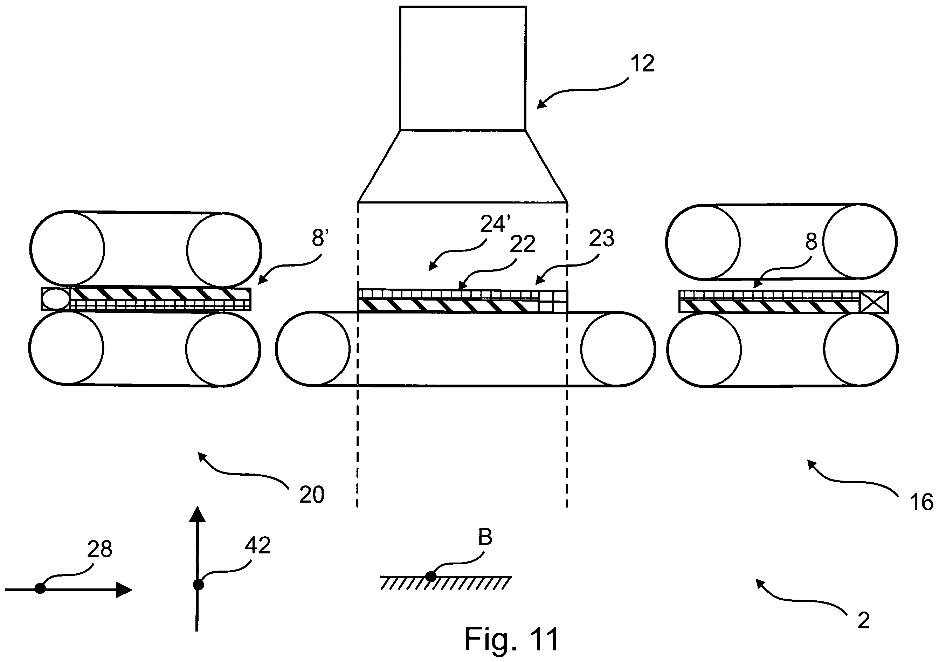

Das erneute Zuführen des zweiten Werkstücks 22 zur Erfassungsvorrichtung 12 ist in FIG. 11 gezeigt. In FIG. 11 ist ebenfalls gezeigt, dass ein weiteres erstes Werkstück 8' dem zweiten Werkstück 22 folgt, so dass ein erfindungsgemäßes Verfahren wiederholend für die aufeinanderfolgenden Werkstücke durch die Erfassungsvorrichtung 2 vorgenommen wird.

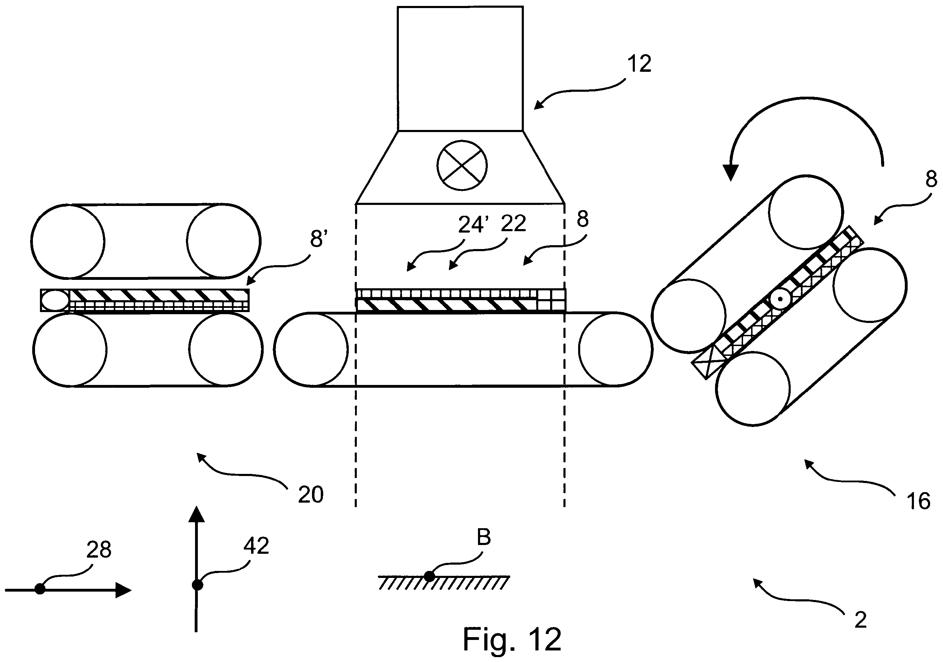

In FIG. 12 ist gezeigt, dass nach dem die Erfassung durch die Erfassungsvorrichtung 12 für ein erstes Werkstück 8 bzw. zweites Werkstück 22 abgeschlossen ist, das erste Wendeorgan 16 oder das zweite Wendeorgan 20 ein ihr zum Wenden zugeführtes Werkstück 8 oder zweites Werkstück 22 derart wendet, dass dessen jeweilige Oberseite 10, 24 wieder bodenabgewandt orientiert ist.

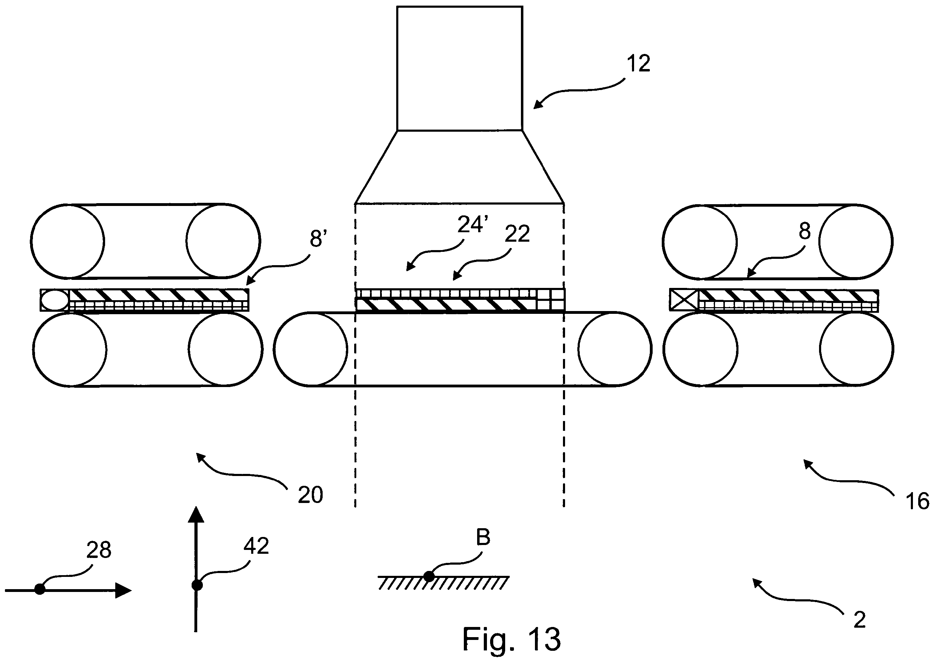

Der Vorgang des abschließenden Wendens ist anhand des ersten Werkstückes 8 in den FIG. 12 und FIG. 13 dargestellt.

Wie anhand der in den Figuren gezeigten Vorgänge zu entnehmen ist, erfolgt ein Wenden eines Werkstückes 8, 22 um eine jeweilige horizontale Achse 44, 44' derart, dass eine Drehung/ein Schwenken des betreffenden Werkstücks 8, 22 um 180 Winkelgrad erfolgt.

Zur Realisierung eines erfindungsgemäßen Verfahrens bzw. einer erfindungsgemäßen Erfassungsvorrichtung 2 ist eine Steuerungseinrichtung vorgesehen, die zur Vereinfachung in den Figuren nicht gezeigt ist. Die Steuerungseinrichtung bewirkt, dass die einzelnen Bestandteile einer Erfassungsvorrichtung 2 gemäß dem jeweiligen Vorgang angesteuert werden. Dabei kann im Rahmen der Erfindung eine Ansteuerung auch eine Regelung umfassen.

Die durch die Erfassungsvorrichtung 12 erfassten Werkzeugabschnitte 14, 8, 23, 26 werden schließlich entsprechend durch eine Auswertungseinrichtung (in den Figuren nicht gezeigt) mittels Datenverarbeitung ausgewertet.

Im Rahmen der Erfindung wurde differenziert zwischen einem ersten Werkstück 8 und einem zweiten Werkstück 22. Diese Differenzierung dient lediglich dazu, die Werkstücke voneinander zu unterscheiden. Die Werkstücke 8, 22 können zueinander gleich wie auch unterschiedlich gebildet sein. Die Differenzierung zwischen erstem Werkstück 8 und zweitem Werkstück 22 dient in erster Linie dazu, die Werkstücke 8, 22 dahingehend zu kennzeichnen, dass ihre Reihenfolge im Hinblick auf die einzelnen Bearbeitungsschritte adressiert werden kann.

Im Hinblick auf die Realisierung eines erfindungsgemäßen Verfahrens bzw. einer erfindungsgemäßen Erfassungsvorrichtung 2 sind weite Grenzen gesetzt.

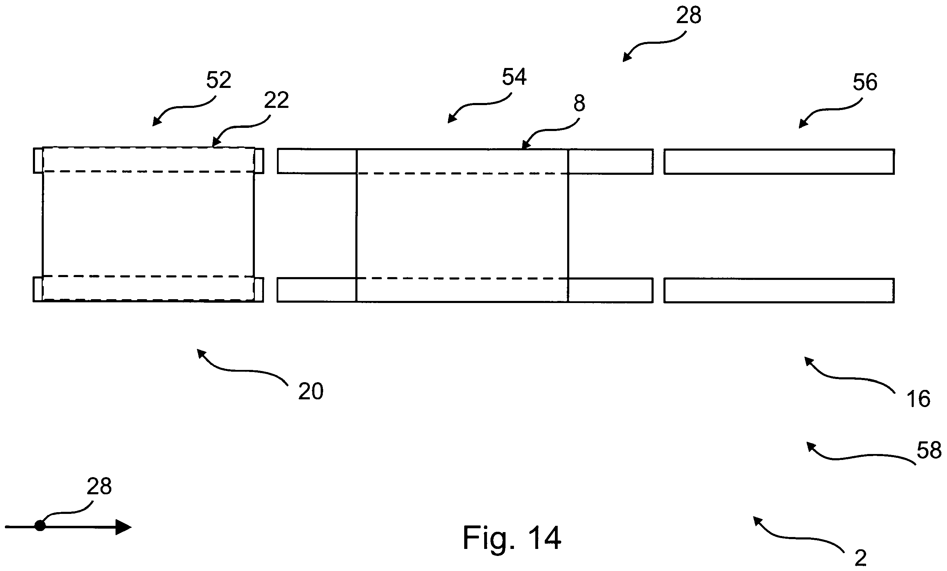

In der FIG. 14 ist beispielsweise die zuvor beschriebene Förderstrecke 28 in einer in FIG. 3 durch A-A gekennzeichneten Ansicht dargestellt, wobei ein erster Abschnitt 52 der Förderstrecke 28 durch das zweite Wendeorgan 20 bestimmt ist. Ein zweiter Abschnitt 54 der Förderstrecke 28 ist im Bereich der Erfassungseinrichtung 12 realisiert. Darüber hinaus ist ein dritter Abschnitt 56 der Förderstrecke 52 durch das erste Wendeorgan 16 bestimmt.

Den vorgenannten Figuren ist die Anordnung der Wendeorgane 16, 20 zur Erfassungsvorrichtung 12 zu entnehmen. Diesbezüglich kann auch eine andersgeartete Anordnung im Rahmen der Erfindung vorgenommen werden, die diesbezüglich auch entsprechend berücksichtigt ist. Die in den Figuren gezeigte Anordnung ist die im Rahmen der Erfindung prädestinierte.

In Fig. 14 ist ersichtlich, dass die Fördermittel derart eingerichtet und ausgebildet sind, eine Förderung des ersten Werkstücks 8 und des zweiten Werkstücks 22 mittels einer gemeinsamen, in diesem Ausführungsbeispiel geradlinigen, Förderspur 58 erfolgt.

Durch die Erfassungsvorrichtung 2 ist anhand der vorstehenden Figuren, dass das erste Werkstück 8 durch das erste Wendeorgan 16 gewendet wird, während die Oberseite 24 des zweiten Werkstücks 22 wenigstens abschnittsweise durch die Erfassungseinrichtung 12 erfasst wird, und insbesondere das zweite Werkstück 22 durch das zweite Wendeorgan 20 gewendet wird, während die Unterseite des ersten Werkstücks 8 wenigstens abschnittsweise durch die Erfassungseinrichtung 12 erfasst wird.

Des Weiteren ist in den Figuren ersichtlich, dass das erste Wendeorgan 16 und das zweite Wendeorgan 20 hinsichtlich der Förderstrecke 28 gleich beabstandet zur Erfassungseinrichtung 12 angeordnet sind.

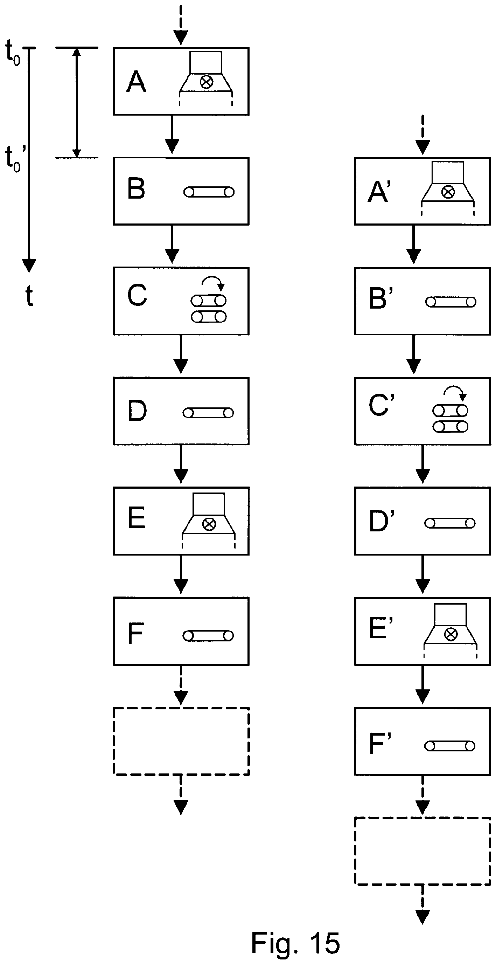

Anhand der Fig. 15 ist das erfindungsgemäße Verfahren nochmals verdeutlicht, welches zuvor anhand einer erfindungsgemäßen Gestaltung einer entsprechenden Erfassungsvorrichtung beschrieben wurde.

Darin ersichtlich sind der erste Verfahrensabschnitte, repräsentiert durch die Verfahrensschritte A bis F, und der zweite Verfahrensabschnitt, repräsentiert durch die Verfahrensschritte A' bis F'. Die einzelnen Verfahrensabschnitte sind gemäß ihrer jeweiligen Verfahrensschritte anhand einer Zeitachse t dargestellt, wodurch dessen Abfolge ersichtlich ist. Der zweite Verfahrensabschnitt beginnt um einen zeitlichen Versatz (t0'-t0) zum ersten Verfahrensabschnitt und läuft ansonsten parallel zum ersten Verfahrensabschnitt ab. Der zeitliche Versatz beträgt bei dem gezeigten Ausführungsbeispiel die Dauer des ersten Erfassens des ersten Werkstückes 8.

Im Vorfeld ist das erste Werkstück 8 der Erfassungseinrichtung 12 mittels der Fördereinrichtung 4 zugeführt worden.

Im Verfahrensschritt A erfolgt die abschnittsweise Erfassung der Oberseite 10 des ersten Werkstückes.

Nach der Erfassung der Oberseite 10 des ersten Werkstücks 8 führen die zur weiteren Erfassung des ersten Werkstückes 8 die Fördermittel 6 das erste Werkstück einem ersten Wendeorgan 16 zu.

Im Verfahrensschritt B erfolgt die Zuführung des erstens Werkstückes zum ersten Wendeorgan 20 durch die Fördermittel 6.

Verfahrensabschritt C ist auf das Wenden des ersten Werkstückes 8 durch das erste Wendeorgan 20 bezogen, welches das ihr zum Wenden zugeführte erste Werkstück 8 derart wendet, dass die Fördermittel 6 das erste Werkstück 8 nach dessen Wenden der Erfassungsvorrichtung 12 zur wenigstens abschnittsweisen Erfassung seiner Unterseite 10' wieder zuführen (Verfahrensschritt D).

Im Verfahrensabschritt E ist bezogen auf eine wenigstens abschnittsweiser Erfassung der Unterseite 10' des ersten Werkstückes 8.

Daraufhin wird im Verfahrensschritt F das erste Werkstück 8 durch die Fördermittel 6 in einer der Erfassungseinrichtung 12 abgewandten Förderrichtung 30 gefördert.

Die Verfahrensschritte A' bis F' des zweiten Verfahrensabschnittes erfolgen analog zum ersten Verfahrensabschnitt.

Dadurch ergibt es sich erfindungsgemäß, dass während des Verfahrensabschnittsmit den zuvor beschrieben Vorgänge zur weiteren Erfassung des zweiten Werkstückes 22 die Erfassungseinrichtung 12 das dem ersten Werkstück 8 nachfolgendes zweite Werkstück 22 wenigstens abschnittsweise erfasst, indem die Fördermittel 6 das zweite Werkstück 22 zur wenigstens abschnittsweisen Erfassung seiner Oberseite 20 der Erfassungseinrichtung 12 und daraufhin einem zweiten Wendeorgan 20 zuführen, welches das ihr zum Wenden zugeführte zweite Werkstück 22 derart wendet, dass die Fördermittel 6 das zweite Werkstück 22 nach dessen Wenden der Erfassungsvorrichtung 12 zur wenigstens abschnittsweisen Erfassung seiner Unterseite 24' mittels der Fördermittel 6 wieder zuführen.

Durch die zeitliche Abstimmung der einzelnen Verfahrensschritte aufeinander ist dadurch erreicht, dass die Erfassungsvorrichtung 12 derart eingerichtet und ausgebildet ist, dass das erste Werkstück 8 durch das erste Wendeorgan 16 gewendet wird, während die Oberseite 24 des zweiten Werkstücks 22 wenigstens abschnittsweise durch die Erfassungseinrichtung 12 erfasst wird, und insbesondere das zweite Werkstück 22 durch das zweite Wendeorgan 20 gewendet wird, während die Unterseite 10' des ersten Werkstücks 8 wenigstens abschnittsweise durch die Erfassungseinrichtung 12 erfasst wird.

## Patentansprüche

1. Verfahren zur Werkstückerfassung
- bei dem mittels Fördermittel (6) ein erstes Werkstück (8, 8') einer optischen Erfassungseinrichtung (12) zugeführt wird, durch die eine Oberseite (10) des Werkstückes (8, 8') wenigstens abschnittsweise erfasst wird,
- wobei,
- in einem ersten Verfahrensabschnitt zur weiteren, optischen Erfassung des ersten Werkstückes (8, 8') das erste Werkstück (8, 8') nach wenigstens abschnittsweiser, optischer Erfassung seiner Oberseite (10) mittels der Fördermittel (6) einem ersten Wendeorgan (16) zugeführt wird, durch das daraufhin das ihr zum Wenden zugeführte erste Werkstück derart gewendet wird, dass das erste Werkstück (8, 8') im gewendeten Zustand mittels der Fördermittel (6) zur wenigstens abschnittsweisen, optischen Erfassung seiner Unterseite (10') wieder zugeführt wird, so dass es nach wenigstens abschnittsweiser, optischer Erfassung seiner Unterseite (10') mittels der Fördermittel (6) in einer der optischen Erfassungseinrichtung (12) abgewandten Förderrichtung (30, 32) gefördert wird,
- wobei während des ersten Verfahrensabschnittes in einem zweiten Verfahrensabschnitt zur optischen Erfassung eines zweiten Werkstückes (22) das dem ersten Werkstück (8) nachfolgende zweite Werkstück (22) der optischen Erfassungseinrichtung (12) zugeführt wird und nach wenigstens abschnittsweiser, optischer Erfassung seiner Oberseite (24) mittels der Fördermittel (6) einem zweiten Wendeorgan (20) zugeführt wird, durch das daraufhin das ihr zum Wenden zugeführte zweite Werkstück (22) derart gewendet wird, dass dieses im gewendeten Zustand der Erfassungseinrichtung (12) zur wenigstens abschnittsweisen Erfassung seiner Unterseite (24') mittels der Fördermittel (6) wieder zugeführt wird,
- **dadurch gekennzeichnet, dass** ein zum Wenden dem ersten oder dem zweiten Wendeorgan (16, 20) zugeführtes Werkstück (8, 8', 22) durch dieses um eine Achse (44, 44') gewendet wird, wobei das erste Werkstück (8) durch das erste Wendeorgan (16) gewendet wird, während die Oberseite (24) des zweiten Werkstücks (22) wenigstens abschnittsweise durch die optische Erfassungseinrichtung (12) erfasst wird, und das zweite Werkstück durch (8) das zweite Wendeorgan (20) gewendet wird, während die Unterseite (10') des ersten Werkstücks (8) wenigstens abschnittsweise durch die optische Erfassungseinrichtung (12) erfasst wird, wobei die Fördermittel (6) erstes und zweites Werkstück (8, 8', 22) entlang einer Förderstrecke (28) fördern, wobei die optische Erfassungsvorrichtung (12) räumlich zwischen erstem Wendeorgan (16) und zweitem Wendeorgan (20) angeordnet ist.

2. Verfahren nach Anspruch 1, **dadurch gekennzeichnet, dass** ein zum Wenden einem Wendeorgan (16, 20) zugeführtes Werkstück (8, 8', 22) durch dieses um eine horizontale Achse um 180 Winkelgrad gewendet wird.

3. Verfahren nach Anspruch 1 oder 2, **dadurch gekennzeichnet, dass** der zweite Verfahrensabschnitt mit dem zweiten Verfahrensabschnitt zeitlich abgestimmt, insbesondere synchronisiert, ist.

4. Verfahren nach einem der vorhergehenden Ansprüche, **dadurch gekennzeichnet, dass** nach wenigstens abschnittsweiser, optischer Erfassung von Ober- und Unterseite (10, 10', 24, 24') eines Werkstückes (8, 8', 22) dieses mittels der Fördermittel (6) dem ersten oder zweiten Wendeorgan (16, 20) zugeführt und daraufhin derart gewendet wird, dass sich dessen jeweilige Oberseite (10, 24) in seiner ursprünglichen Orientierung vor dessen optischer Erfassung durch die optische Erfassungseinrichtung (12) befindet.

5. Verfahren nach einem der vorhergehenden Ansprüche, **dadurch gekennzeichnet, dass** das erste Werkstück (8, 8') durch das erste Wendeorgan (16) gewendet wird, während die Unterseite (24') des zweiten Werkstücks (22) wenigstens abschnittsweise durch die optische Erfassungseinrichtung (12) erfasst wird und insbesondere das zweite Werkstück (22) durch das erste Wendeorgan (16) gewendet wird, während die Oberseite eines weiteren ersten Werkstücks (8') wenigstens abschnittsweise durch die optische Erfassungseinrichtung (12) erfasst wird.

6. Verfahren nach einem der vorhergehenden Ansprüche, **dadurch gekennzeichnet, dass** die Fördermittel (6) das zweite Werkstück (22) der optischen Erfassungseinrichtung (12) zum optischen Erfassen oder dem zweiten Wendeorgan (20) zum Wenden zuführen, während sie das erste Werkstück (8) dem ersten Wendeorgan (16) oder der optischen Erfassungseinrichtung (12) zum Erfassen zuführen.

7. Verfahren nach einem der vorhergehenden Ansprüche, **dadurch gekennzeichnet, dass** die Fördermittel (6) für die wenigstens abschnittsweisen, optischen Erfassung der Unterseite (10') des ersten Werkstückes (8, 8') durch die optische Erfassungseinrichtung (12) bzw. für das Wenden des zweiten Werkstückes (22) durch das zweite Wendeorgan (20) die Förderrichtung (30, 32) für das jeweilige Werkstück (8, 8', 22) umkehren, so dass das jeweilige Werkstück (8, 8', 22) zur optischen Erfassungseinrichtung (12) oder zum Wendeorgan (16, 20) rückgeführt wird.

8. Verfahren nach einem der vorhergehenden Ansprüche, **dadurch gekennzeichnet, dass** das erste Werkstück (8, 8') und das zweite Werkstück (22) durch die Fördermittel (6) mittels einer gemeinsamen, insbesondere geradlinigen, Förderspur (58) gefördert wird.

9. Verfahren nach einem der vorhergehenden Ansprüche, **dadurch gekennzeichnet, dass** ein Werkstück (8, 8', 22) durch wenigstens eines der Wendeorgane (16, 20) dadurch gewendet wird, indem wenigstens ein erster Stetigförderer (38, 40) und ein zweiter Stetigförderer (38', 40') um eine gemeinsame, insbesondere horizontale, Achse (44, 44') gedreht werden, sobald sich das Werkstück (8, 8', 22) auf dem ersten Stetigförderer aufliegend zwischen erstem und dem zweiten Stetigförderer (38, 40, 38', 40') in einer Wendeposition befindet, und danach durch den zweiten Stetigförderer (38', 40') in einer der optischen Erfassungseinrichtung (12) zugewandten oder abgewandten Richtung gefördert wird.

10. Verfahren nach einem der vorhergehenden Ansprüche, **dadurch gekennzeichnet, dass** die durch die optische Erfassungseinrichtung (12) erfassten Daten einer Auswertungseinrichtung zur Datenverarbeitung bereitgestellt werden.

11. Erfassungsvorrichtung (2) zur Durchführung eines Verfahrens nach einem der vorhergehenden Ansprüche,
- mit einer Fördereinrichtung (4), dessen Fördermittel eingerichtet sind (6) ein erstes Werkstück (8, 8') einer optischen Erfassungseinrichtung (12) zuzuführen, die eingerichtet ist eine Oberseite (10, 24) des Werkstückes (8, 22) wenigstens optisch, abschnittsweise zu erfassen,
- mit einem ersten und einem zweiten Wendeorgan (16, 20),
- wobei Steuerungsmittel vorgesehen sind, die bewirken,
- dass zur weiteren optischen Erfassung des ersten Werkstückes (8, 8') die Fördermittel (6) das erste Werkstück (8, 8') nach wenigstens optischer, abschnittsweiser Erfassung seiner Oberseite (10) dem ersten Wendeorgan (16) zuführen, welches das ihr zum Wenden zugeführte erste Werkstück (8, 8') derart wendet, dass die Fördermittel (6) das erste Werkstück (8, 8') nach dessen Wenden der optischen Erfassungsvorrichtung (12) zur wenigstens optischen, abschnittsweisen Erfassung seiner Unterseite (10') wieder zuführen und nach wenigstens optischer, abschnittsweiser Erfassung seiner Unterseite (10') in einer der optischen Erfassungseinrichtung (12) abgewandten Förderrichtung (30, 32) fördern,
- wobei während der weiteren Erfassung des ersten Werkstückes (8, 8') die optische Erfassungseinrichtung (12) ein dem ersten Werkstück (8) nachfolgendes zweites Werkstück (22) wenigstens optisch, abschnittsweise erfasst, indem die Fördermittel (6) das zweite Werkstück (22) zur wenigstens optischen, abschnittsweisen Erfassung seiner Oberseite (24) der optischen Erfassungseinrichtung (12) und daraufhin dem zweiten Wendeorgan (20) zuführen, welches das ihr zum Wenden zugeführte zweite Werkstück (22) derart wendet, dass die Fördermittel (6) das zweite Werkstück (22) nach dessen Wenden der optischen Erfassungsvorrichtung (12) zur wenigstens abschnittsweisen optischen Erfassung seiner Unterseite (24') mittels der Fördermittel (6) wieder zuführen,
- **dadurch gekennzeichnet, dass** das erste Wendeorgan (16) und das zweite Wendeorgan (20) derart eingerichtet und ausgebildet sind, dass das erste Wendeorgan (16) und das zweite Wendeorgan (20) ein diesen zum Wenden zugeführtes Werkstück (8, 8', 22) um eine Achse (44, 44') wendet, wobei die Steuerungsmittel weiterhin bewirken, dass das erste Werkstück (8, 8') durch das erste Wendeorgan (16) gewendet wird, während die Oberseite (24') des zweiten Werkstücks (22) wenigstens optisch, abschnittsweise durch die optische Erfassungseinrichtung (12) erfasst wird, und das zweite Werkstück (22) durch das zweite Wendeorgan (20) gewendet wird, während die Unterseite (10') des ersten Werkstücks (8) wenigstens optisch, abschnittsweise durch die optische Erfassungseinrichtung (12) erfasst wird, wobei die Fördermittel (6) eingerichtet sind, erstes und zweites Werkstück (8, 8', 22) entlang einer Förderstrecke (28) zu fördern, und die optische Erfassungsvorrichtung (12) räumlich zwischen erstem Wendeorgan (16) und zweitem Wendeorgan (20) angeordnet ist.

12. Erfassungsvorrichtung nach Anspruch 11, **dadurch gekennzeichnet, dass** das erste Wendeorgan (16) und / oder das zweite Wendeorgan (20) derart eingerichtet und ausgebildet ist, dass das erste Wendeorgan (16) und / oder das zweite Wendeorgan (20) ein diesen zum Wenden zugeführtes Werkstück (8, 8', 22) um die horizontale Achse (44, 44') um 180 Winkelgrad wendet.

13. Erfassungsvorrichtung nach Anspruch 11 oder 12, **dadurch gekennzeichnet, dass** das erste Wendeorgan (16) und das zweiten Wendeorgan (22) derart eingerichtet und ausgebildet sind, dass ein Wenden eines Werkstücks (8, 22) durch das jeweiligen Wendeorgan (16, 20) zeitlich abgestimmt, insbesondere synchronisiert, ist zum wenigstens abschnittsweisen, optischen Erfassen einer Oberseite (10, 24) bzw. einer Unterseite (10', 24') eines Werkstückes (22, 8).

14. Erfassungsvorrichtung nach einem der Ansprüche 11 bis 13, **dadurch gekennzeichnet, dass** das erste Wendeorgan (16) und das zweite Wendeorgan (20) hinsichtlich einer Förderstrecke (28) gleich beabstandet zur optischen Erfassungseinrichtung (12) angeordnet sind.

15. Erfassungsvorrichtung nach einem der Ansprüche 11 bis 14, **dadurch gekennzeichnet, dass** die Fördermittel (6) derart eingerichtet und ausgebildet sind, eine Förderung des ersten Werkstücks (8, 8', 22) und des zweiten Werkstücks (22) mittels einer gemeinsamen, insbesondere geradlinigen, Förderspur (58) erfolgt.

16. Erfassungsvorrichtung nach einem der Ansprüche 11 bis 15, **dadurch gekennzeichnet, dass** die Fördermittel (6) wenigstens einen Stetigförderer (38, 40, 38', 40') zur wenigstens abschnittsweisen Förderung eines Werkstückes (8, 8', 22) aufweisen.

17. Erfassungsvorrichtung nach einem der Ansprüche 11 bis 16, **dadurch gekennzeichnet, dass** erste Wendeorgan (16) und /oder das zweite Wendeorgan (20) wenigstens einen unteren Stetigförderer (38, 38') und einen oberen Stetigförderer (40, 40') aufweisen, die derart in vertikaler Richtung (42) übereinander und zueinander beabstandet angeordnet sind, dass sich zum Wenden das erste oder zweite Werkstück (8, 8', 22) auf dem ersten Stetigförderer (38, 38') aufliegend zwischen erstem und dem zweiten Stetigförderer (38, 40, 38', 40') befindet, so dass ein gemeinsames Drehen vom jeweiligen ersten und zweiten Stetigförderer (38, 40, 38', 40') um eine, gemeinsame, vorzugsweise horizontale, Achse (44, 44') bewirkt, dass das zum Wenden vorgesehene Werkstück (8, 8', 22) auf dem zweiten Stetigförderer (40, 40') aufliegt und durch diesen förderbar ist.

18. Erfassungsvorrichtung nach Anspruch 17, **dadurch gekennzeichnet, dass** der Abstand zwischen erstem Stetigförderer (38, 38') und zweitem Stetigförderer (40, 40') verstellbar, insbesondere automatisiert verstellbar ist, derart, dass das Werkstück (8, 38', 22) zwischen den Stetigförderern (38, 40, 38', 40') einführbar ist und der Abstand für einen Wendevorgang für ein verschiebungsminimiertes Halten des Werkstücks verringerbar ist.

## Claims

1. Method for workpiece detection
- in which by means of conveying means (6), a first workpiece (8, 8') is delivered to an optical detection device (12), by means of which an upper side (10) of the workpiece (8, 8') is detected at least section-wise,
- wherein,
- in a first method section for further, optical detection of the first workpiece (8, 8'), the first workpiece (8, 8'), after at least section-wise, optical detection of its upper side (10) is delivered by means of the conveying means (6) to a first turning element (16), by means of which after that the first workpiece delivered to it for turning, is turned such that the first workpiece (8, 8') in the turned state, is delivered again by means of the conveying means (6) for at least section-wise, optical detection of its lower side (10') so that, after at least section-wise, optical detection of its lower side (10'), it is conveyed by means of the conveying means (6) in a conveying direction (30, 32) facing away from the optical detection device (12),
- wherein during the first method section, in a second method section for optical detection of a second workpiece (22), the second workpiece (22) following the first workpiece (8) is delivered to the optical detection device (12) and, after at least section-wise, optical detection of its upper side (24), is delivered by means of the conveying means (6) to a second turning element (20), by means of which after that the second workpiece (22) delivered to it for turning, is turned such that the latter in the turned state is delivered again by means of the conveying means (6) to the detection device (12) for at least section-wise detection of its lower side (24'),
- **characterised in that** a workpiece (8, 8', 22) delivered for turning to the first or the second turning element (16, 20) is turned by the latter about an axis (44, 44'), wherein the first workpiece (8) is turned by the first turning element (16), while the upper side (24) of the second workpiece (22) is detected at least section-wise by the optical detection device (12), and the second workpiece is turned by (8) the second turning element (20), while the lower side (10') of the first workpiece (8) is detected at least section-wise by the optical detection device (12), wherein the conveying means (6) convey first and second workpiece (8, 8', 22) along a conveying path (28), wherein the optical detection device (12) is arranged spatially between first turning element (16) and second turning element (20).

2. Method according to claim 1, **characterised in that** a workpiece (8, 8', 22) delivered to a turning element (16, 20) for turning, is turned by the latter about a horizontal axis by 180 angular degrees.

3. Method according to claim 1 or 2, **characterised in that** the second method section is matched in time, in particular synchronised, with the second method section.

4. Method according to one of the preceding claims, **characterised in that**, after at least section-wise, optical detection of upper side and lower side (10, 10', 24, 24') of a workpiece (8, 8', 22), the latter is delivered by means of the conveying means (6) to the first or second turning element (16, 20) and after that turned such that its respective upper side (10, 24) is located in its original orientation before its optical detection by the optical detection device (12).

5. Method according to one of the preceding claims, **characterised in that** the first workpiece (8, 8') is turned by the first turning element (16), while the lower side (24') of the second workpiece (22) is detected at least section-wise by the optical detection device (12) and in particular the second workpiece (22) is turned by the first turning element (16), while the upper side of a further first workpiece (8') is detected at least section-wise by the optical detection device (12).

6. Method according to one of the preceding claims, **characterised in that** the conveying means (6) deliver the second workpiece (22) to the optical detection device (12) for optical detection or to the second turning element (20) for turning, while they deliver the first workpiece (8) to the first turning element (16) or to the optical detection device (12) for detection.

7. Method according to one of the preceding claims, **characterised in that** the conveying means (6) reverse the conveying direction (30, 32) for the respective workpiece (8, 8', 22) for the at least section-wise, optical detection of the lower side (10') of the first workpiece (8, 8') by the optical detection device (12) or for turning the second workpiece (22) by the second turning element (20) so that the respective workpiece (8, 8', 22) is returned to the optical detection device (12) or to the turning element (16, 20).

8. Method according to one of the preceding claims, **characterised in that** the first workpiece (8, 8') and the second workpiece (22) is conveyed by the conveying means (6) by means of a common, in particular straight-line, conveying track (58).

9. Method according to one of the preceding claims, **characterised in that** a workpiece (8, 8', 22) is turned by at least one of the turning elements (16, 20), **in that** at least one first continuous conveyer (38, 40) and a second continuous conveyer (38', 40') are rotated about a common, in particular horizontal, axis (44, 44') as soon as the workpiece (8, 8', 22) resting on the first continuous conveyer is located between first and the second continuous conveyer (38, 40, 38', 40') in a turning position, and then is conveyed by the second continuous conveyer (38', 40') in a direction facing or facing away from the optical detection device (12).

10. Method according to one of the preceding claims, **characterised in that** the data detected by the optical detection device (12) are made available to an evaluating device for data processing.

11. Detection device (2) for carrying out a method according to one of the preceding claims,
- having a conveying device (4), the conveying means (6) of which are equipped to deliver a first workpiece (8, 8') to an optical detection device (12) which is equipped to detect an upper side (10, 24) of the workpiece (8, 22) at least optically, section-wise,
- having a first and a second turning element (16, 20),
- wherein control means are provided which ensure
- that for further optical detection of the first workpiece (8, 8'), the conveying means (6) deliver the first workpiece (8, 8'), after at least optical, section-wise detection of its upper side (10), to the first turning element (16) which turns the first workpiece (8, 8') delivered to it for turning such that the conveying means (6) again deliver the first workpiece (8, 8'), after turning thereof, to the optical detection device (12) for at least optical, section-wise detection of its lower side (10') and, after at least optical, section-wise detection of its lower side (10'), convey in a conveying direction (30, 32) facing away from the optical detection device (12),
- wherein during the further detection of the first workpiece (8, 8'), the optical detection device (12) detects a second workpiece (22) following the first workpiece (8) at least optically, section-wise, in that the conveying means (6) deliver the second workpiece (22) for at least optical, section-wise detection of its upper side (24) to the optical detection device (12) and after that to the second turning element (20) which turns the second workpiece (22) delivered to it for turning such that the conveying means (6) again deliver by means of the conveying means (6) the second workpiece (22), after turning thereof, to the optical detection device (12) for at least section-wise optical detection of its lower side (24'),
- **characterised in that** the first turning element (16) and the second turning element (20) are equipped and designed such that the first turning element (16) and the second turning element (20) turns a workpiece (8, 8', 22) delivered to the latter for turning about an axis (44, 44'), wherein the control means furthermore ensure that the first workpiece (8, 8') is turned by the first turning element (16), while the upper side (24') of the second workpiece (22) is detected at least optically, section-wise by the optical detection device (12), and the second workpiece (22) is turned by the second turning element (20), while the lower side (10') of the first workpiece (8) is detected at least optically, section-wise by the optical detection device (12), wherein the conveying means (6) are equipped to convey first and second workpiece (8, 8', 22) along a conveying path (28), and the optical detection device (12) is arranged spatially between first turning element (16) and second turning element (20).

12. Detection device according to claim 11, **characterised in that** the first turning element (16) and/or the second turning element (20) is equipped and designed such that the first turning element (16) and/or the second turning element (20) turns a workpiece (8, 8', 22) delivered to the latter for turning about the horizontal axis (44, 44') by 180 angular degrees.

13. Detection device according to claim 11 or 12, **characterised in that** the first turning element (16) and the second turning element (22) are equipped and designed such that turning of a workpiece (8, 22) by the respective turning element (16, 20) is matched in time, in particular synchronised, for at least section-wise, optical detection of an upper side (10, 24) or a lower side (10', 24') of a workpiece (22, 8).

14. Detection device according to one of claims 11 to 13, **characterised in that** the first turning element (16) and the second turning element (20) are arranged with regard to a conveying path (28) to be equally spaced from the optical detection device (12).

15. Detection device according to one of claims 11 to 14, **characterised in that** the conveying means (6) are equipped and designed such that conveying of the first workpiece (8, 8', 22) and of the second workpiece (22) is effected by means of a common, in particular straight-line, conveying track (58).

16. Detection device according to one of claims 11 to 15, **characterised in that** the conveying means (6) have at least one continuous conveyer (38, 40, 38', 40') for at least section-wise conveying of a workpiece (8, 8', 22).

17. Detection device according to one of claims 11 to 16, **characterised in that** first turning element (16) and/or the second turning element (20) have at least one lower continuous conveyer (38, 38') and an upper continuous conveyer (40, 40') which are arranged in vertical direction (42) one above another and spaced from one another such that for turning, the first or second workpiece (8, 8', 22) resting on the first continuous conveyer (38, 38') is located between first and the second continuous conveyer (38, 40, 38', 40') so that common rotation of the respective first and second continuous conveyer (38, 40, 38', 40') about a common, preferably horizontal, axis (44, 44') ensures that the workpiece (8, 8', 22) provided for turning rests on the second continuous conveyer (40, 40') and can be conveyed by the latter.

18. Detection device according to claim 17, **characterised in that** the distance between first continuous conveyer (38, 38') and second continuous conveyer (40, 40') can be adjusted, in particular can be adjusted in automated manner, such that the workpiece (8, 38', 22) can be introduced between the continuous conveyers (38, 40, 38', 40') and the distance for a turning process can be reduced for displacement-minimised holding of the workpiece.

## Revendications

1. Procédé de détection de pièce
- dans lequel, au moyen de moyens de transport (6), une première pièce (8, 8') est acheminée à un équipement de détection (12) optique par lequel un côté supérieur (10) de la première pièce (8, 8') est détecté au moins partiellement,
- dans lequel,
- dans une première étape de procédé de détection optique complémentaire de la première pièce (8, 8'), la première pièce (8, 8') est, après une détection optique au moins partielle de son côté supérieur (10), acheminée au moyen des moyens de transport (6) à un premier organe de retournement (16) par lequel ensuite la première pièce qui lui est acheminée pour le retournement est retournée de telle sorte que la première pièce (8, 8'), dans l'état retourné, est de nouveau acheminée au moyen des moyens de transport (6), pour la détection optique au moins partielle de son côté inférieur (10') de telle sorte que, après une détection optique au moins partielle de son côté inférieur (10'), la pièce est transportée au moyen des moyens de transport (6) dans une direction de transport (30, 32) opposée au dispositif de détection (12) optique,
- dans lequel, pendant la première étape de procédé, dans une deuxième étape de procédé de détection optique d'une deuxième pièce (22), la deuxième pièce (22) qui suit la première pièce (8) est acheminée à l'équipement de détection (12) optique et, après une détection optique au moins partielle de son côté supérieur (24), est acheminée au moyen des moyens de transport (6) à un deuxième organe de retournement (20) par lequel ensuite la deuxième pièce (22) qui lui est acheminée pour le retournement est retournée de telle sorte que celle-ci, dans l'état retourné, est acheminée de nouveau à l'équipement de détection (12) au moyen des moyens de transport (6) pour la détection au moins partielle de son côté inférieur (24'),
- **caractérisé en ce qu'**une pièce (8, 8', 22) acheminée pour le retournement au premier ou au deuxième organe de retournement (16, 20) est retournée par celui-ci autour d'un axe (44, 44'), la première pièce (8) étant retournée par le premier organe de retournement (16) pendant que le côté supérieur (24) de la deuxième pièce (22) est détecté au moins partiellement par l'équipement de détection (12) optique, et la deuxième pièce (8) est retournée par le deuxième organe de retournement (20) pendant que le côté inférieur (10') de la première pièce (8) est détecté au moins partiellement par l'équipement de détection (12) optique, les moyens de transport (6) transportant la première et la deuxième pièce (8, 8', 22) le long d'une trajectoire de transport (28), l'équipement de détection (12) optique étant disposé spatialement entre le premier organe de retournement (16) et le deuxième organe de retournement (20).

2. Procédé selon la revendication 1, **caractérisé en ce qu'**une pièce (8, 8', 22) acheminée à un organe de retournement (16, 20) pour le retournement est retournée par celui-ci de 180 degrés d'angle autour d'un axe horizontal.

3. Procédé selon la revendication 1 ou 2, **caractérisé en ce que** la deuxième étape de procédé est harmonisée chronologiquement avec la deuxième étape de procédé, en particulier synchronisée.

4. Procédé selon l'une des revendications précédentes, **caractérisé en ce que**, après une détection optique au moins partielle du côté supérieur et du côté inférieur (10, 10', 24, 24') d'une pièce (8, 8', 22), cette pièce est acheminée au premier ou au deuxième organe de retournement (16, 20) au moyen des moyens de transport (6) et ensuite est retournée de telle sorte que son côté supérieur (10, 24) respectif se trouve dans son orientation initiale avant sa détection optique par l'équipement de détection (12) optique.

5. Procédé selon l'une des revendications précédentes, **caractérisé en ce que** la première pièce (8, 8') est retournée par le premier organe de retournement (16) pendant que le côté inférieur (24') de la deuxième pièce (22) est détecté au moins partiellement par l'équipement de détection (12) optique, et en particulier la deuxième pièce (22) est retournée par le premier organe de retournement (16) pendant que le côté supérieur d'une autre première pièce (8') est détecté au moins partiellement par l'équipement de détection (12) optique.

6. Procédé selon l'une des revendications précédentes, **caractérisé en ce que** les moyens de transport (6) acheminent la deuxième pièce (22) à l'équipement de détection (12) optique pour la détection optique ou au deuxième organe de retournement (20) pour le retournement pendant qu'ils acheminent la première pièce (8) au premier organe de retournement (16) ou à l'équipement de détection (12) pour la détection.

7. Procédé selon l'une des revendications précédentes, **caractérisé en ce que** les moyens de transport (6) pour la détection optique au moins partielle du côté inférieur (10') de la première pièce (8, 8') par l'équipement de détection (12) optique ou respectivement pour le retournement de la deuxième pièce (22) par le deuxième organe de retournement (20) inversent la direction de transport (30, 32) pour la pièce (8, 8', 22) respective de telle sorte que la pièce (8, 8', 22) respective est renvoyée à l'équipement de détection (12) optique ou à l'organe de retournement (16, 20).

8. Procédé selon l'une des revendications précédentes, **caractérisé en ce que** la première pièce (8, 8') et la deuxième pièce (22) sont transportées par les moyens de transport (6) au moyen d'une voie de transport (58) commune, en particulier rectiligne.

9. Procédé selon l'une des revendications précédentes, **caractérisé en ce qu'**une pièce (8, 8', 22) est retournée par au moins l'un des organes de retournement (16, 20) par le fait qu'au moins un premier convoyeur en continu (38, 40) et un deuxième convoyeur en continu (38', 40') sont mis en rotation autour d'un axe (44, 44') commun, en particulier horizontal dès que la pièce (8, 8', 22) repose sur le premier convoyeur en continu entre le premier et le deuxième convoyeur en continu (38, 40, 38', 40') dans une position de retournement, et ensuite est transportée par le deuxième convoyeur en continu (38', 40') dans une direction vers ou à l'opposé de l'équipement de détection (12) optique.

10. Procédé selon l'une des revendications précédentes, **caractérisé en ce que** les données détectées par l'équipement de détection (12) optique sont fournies à un équipement d'analyse en vue du traitement des données.

11. Dispositif de détection (2) destiné à la réalisation d'un procédé selon l'une des revendications précédentes,
- avec un équipement de transport (4) dont les moyens de transport (6) sont agencés pour acheminer une première pièce (8, 8') à un équipement de détection (12) optique qui est agencé pour détecter un côté supérieur (10, 24) de la pièce (8, 22) au moins en partie optiquement,
- avec un premier et un deuxième organe de retournement (16, 20),
- des moyens de commande étant prévus, qui ont pour effet que
- pour la détection optique complémentaire de la première pièce (8, 8'), les moyens de transport (6) acheminent la première pièce (8, 8'), après une détection au moins en partie optique de son côté supérieur (10), au premier organe de retournement (16) qui retourne la première pièce (8, 8') qui lui est acheminée pour le retournement de telle sorte que les moyens de transport (6) acheminent de nouveau la première pièce (8, 8') après son retournement à l'équipement de détection (12) optique pour la détection au moins en partie optique de son côté inférieur (10') et, après une détection au moins en partie optique de son côté inférieur (10'), l'acheminent dans une direction de transport (30, 32) à l'opposé de l'équipement de détection (12) optique,
- où, pendant la détection complémentaire de la première pièce (8, 8'), l'équipement de détection (12) optique détecte au moins en partie optiquement une deuxième pièce (22) qui suit la première pièce (8) par le fait que les moyens de transport (6) acheminent la deuxième pièce (22) à l'équipement de détection (12) optique pour la détection au moins en partie optique de son côté supérieur (24) et ensuite l'acheminent au deuxième organe de retournement (20) qui retourne la deuxième pièce (22) qui lui est acheminée pour le retournement de telle sorte que les moyens de transport (6) acheminent de nouveau la deuxième pièce (22) après son retournement à l'équipement de détection (12) optique pour la détection au moins en partie optique de son côté inférieur (24') au moyen des moyens de transport (6),
- **caractérisé en ce que** le premier organe de retournement (16) et le deuxième organe de retournement (20) sont agencés et constitués de telle sorte que le premier organe de retournement (16) et le deuxième organe de retournement (20) retournent autour de son axe (44, 44') une pièce (8, 8', 22) acheminée à ceux-ci pour le retournement,
- les moyens de commande ayant en outre pour effet que la première pièce (8, 8') est retournée par le premier organe de retournement (16) pendant que le côté inférieur (24') de la deuxième pièce (22) est détecté au moins en partie optiquement par l'équipement de détection (12) optique, et la deuxième pièce (22) est retournée par le deuxième organe de retournement (20) pendant que le côté inférieur (10') de la première pièce (8) est détecté au moins en partie optiquement par l'équipement de détection (12) optique, les moyens de transport (6) étant agencés pour transporter la première et la deuxième pièce (8, 8', 22) le long d'une trajectoire de transport (28), et l'équipement de détection (12) optique étant disposé spatialement entre le premier organe de retournement (16) et le deuxième organe de retournement (20).

12. Dispositif de détection selon la revendication 11, **caractérisé en ce que** le premier organe de retournement (16) et/ou le deuxième organe de retournement (20) est agencé et constitué de telle sorte que le premier organe de retournement (16) et/ou le deuxième organe de retournement (20) retourne de 180 degrés d'angle autour de l'axe horizontal (44, 44') une pièce (8, 8', 22) acheminée à ceux-ci pour le retournement.

13. Dispositif de détection selon la revendication 11 ou 12, **caractérisé en ce que** le premier organe de retournement (16) et le deuxième organe de retournement (22) sont agencés et constitués de telle sorte qu'un retournement d'une pièce (8, 22) par l'organe de retournement (16, 20) respectif est harmonisé chronologiquement, en particulier synchronisé, pour la détection au moins en partie optique d'un côté supérieur (10, 24) ou respectivement d'un côté inférieur (10', 24') d'une pièce (22, 8).

14. Dispositif de détection selon l'une des revendications 11 à 13, **caractérisé en ce que** le premier organe de retournement (16) et le deuxième organe de retournement (20) sont, par rapport à une trajectoire de transport (28), disposés à égale distance de l'équipement de détection (12) optique.

15. Dispositif de détection selon l'une des revendications 11 à 14, **caractérisé en ce que** les moyens de transport (6) sont agencés et constitués de telle sorte qu'un transport de la première pièce (8, 8', 22) et de la deuxième pièce (22) s'effectue au moyen d'une voie de transport (58) commune, en particulier rectiligne.

16. Dispositif de détection selon l'une des revendications 11 à 15, **caractérisé en ce que** les moyens de transport (6) comportent au moins un convoyeur en continu (38, 40, 38', 40') pour le transport au moins partiel d'une pièce (8, 8', 22).

17. Dispositif de détection selon l'une des revendications 11 à 16, **caractérisé en ce que** le premier organe de retournement (16) et/ou le deuxième organe de retournement (20) comportent au moins un convoyeur en continu (38, 38') inférieur et un convoyeur en continu (40, 40') supérieur qui sont disposés l'un au-dessus de l'autre dans la direction verticale (42) et espacés l'un de l'autre de telle sorte que, pour le retournement, la première ou la deuxième pièce (8, 8', 22) repose sur le premier convoyeur en continu (38, 38') entre le premier et le deuxième convoyeur en continu (38, 40, 38', 40') de sorte qu'un retournement commun du premier et deuxième convoyeur en continu (38, 40, 38', 40') respectif autour d'un axe (44, 44') commun, de préférence horizontal, a pour effet que la pièce (8, 8', 22) prévue pour le retournement repose sur le deuxième convoyeur en continu (40, 40') et peut être transportée par celui-ci.

18. Dispositif de détection selon la revendication 17, **caractérisé en ce que** la distance entre le premier convoyeur en continu (38, 38') et le deuxième convoyeur en continu (40, 40') peut être réglée, en particulier peut être réglée automatiquement, de telle sorte que la pièce (8, 38', 22) peut être introduite entre les convoyeurs en continu (38, 40, 38', 40'), et la distance pour un processus de retournement peut être réduite pour favoriser un maintien de la pièce avec coulissement minimal.
